# EUROPEAN PATENT SPECIFICATION

(11) **EP 1 398 784 B1**
(45) Date of publication and mention of the grant of the patent: **17.10.2012**
(21) Application number: 03024893.4
(22) Date of filing: 02.02.2001
(51) Int. Cl.: G11C 7/06, G11C 11/419, G11C 11/418, G11C 8/12

(54) **Memory module with hierarchical functionality**
Speichermodul mit hierarchischer Funkionalität
Module de mémoire à fonctionnalité hiérarchique

(30) Priority: 02.02.2000 US 179777 P; 02.02.2000 US 179766 P; 02.02.2000 US 179866 P; 02.02.2000 US 179718 P; 02.02.2000 US 179765 P; 02.02.2000 US 179768 P; 02.02.2000 US 179865 P; 31.03.2000 US 193607 P; 31.03.2000 US 193606 P; 31.03.2000 US 193605 P; 29.06.2000 US 215741 P; 25.07.2000 US 220567 P; 02.02.2001 US 775477; 02.02.2001 US 776263; 02.02.2001 US 776028; 02.02.2001 US 775701; 02.02.2001 US 775475; 02.02.2001 US 776029; 02.02.2001 US 775478; 02.02.2001 US 776220; 02.02.2001 US 775476; 02.02.2001 US 776262
(43) Date of publication of application: 17.03.2004
(62) Divisional of application: 01905334.7
(73) Proprietor: Broadcom Corporation, Irvine, CA 92617 (US)
(72) Inventor: Terzioglu, Esin, Aliso Viejo CA 92656 (US); Afghahi, Morteza Cyrus, 92692 Mission Viejo California (US); Hatamian, Mehdi, 92618-3616 Irvine, CA (US)
(74) Representative: Jehle, Volker Armin

(56) References cited:
- US-A- 4 984 202
- US-A- 5 734 616
- US-A- 5 751 648
- US-A- 6 009 024

## Description

### CROSS-REFERENCE TO RELATED APPLICATION(S)

The present application claims the benefit of the filing dates of the following United States Provisional Patent Applications.

Serial No. 60/215,741, filed June 29, 2000, and entitled MEMORY MODULE WITH HIERARCHICAL FUNCTIONALITY; Serial No. 60/193,607, filed March 31, 2000, and entitled MEMORY REDUNDANCY IMPLEMENTATION; Serial No. 60/193,606, filed March 31,2000, and entitled DIFFUSION REPLICA DELAY CIRCUIT; Serial No. 60/179,777, filed February 2,2000, and entitled SPLIT DUMMY BITLINES FOR FAST, LOW POWER MEMORY; Serial No. 60/193,605, filed March 31,2000, and entitled A CIRCUIT TECHNIQUE FOR HIGH SPEED LOW POWER DATA TRANSFER BUS; Serial No. 60/179,766, filed February 2, 2000, and entitled FAST DECODER WITH ASYNCHRONOUS RESET; Serial No. 60/220,567, filed July 25, 2000, and entitled FAST DECODER WITH ROW REDUNDANCY; Serial No. 60/179,866, filed February 2,2000, and entitled HIGH PRECISION DELAY MEASUREMENT CIRCUIT; Serial No. 60/179,718, filed February 2, 2000, and entitled LIMITED SWING DRIVER CIRCUIT; Serial No. 60/179,765, filed February 2, 2000, and entitled SINGLE-ENDED SENSE AMPLIFIER WITH SAMPLE-AND-HOLD REFERENCE; Serial No. 60/179,768, filed February 2, 2000, and entitled SENSE AMPLIFIER WITH OFFSET CANCELLATION AND CHARGE-SHARE LIMITED SWING DRIVERS; and Serial No. 60/179,865, filed February 2,2000, and entitled MEMORY ARCHITECTURE WITH SINGLE PORT CELL AND DUAL PORT (READ AND WRITE) FUNCTIONALITY.

The following patent applications, assigned to the same assignee hereof and filed on even date herewith in the names of the same inventors as the present application, disclose related subject matter:
Memory Module with Hierarchical Functionality, Attorney Docket No. 40050/B600/JFO; High Precision Delay Measurement I Circuit, Attorney Docket No. 37079/B600/JFO; Single-Ended Sense Amplifier with Sample-and-Hold Reference, Attorney Docket No. 37362/B600/JFO; Limited Switch Driver Circuit, Attorney Docket No. 37361/B600/JFO; Fast Decoder with Asynchronous Reset with Row Redundancy; Attorney Docket No. 37115/B600/JFO; Diffusion Replica Delay Circuit, Attorney Docket No. 37360/B600/JFO; Sense Amplifier with Offset Cancellation and Charge-Share Limited Swing Drivers, Attorney Docket No. 37363/B600/JFO; Memory Architecture with Single-Port Cell and Dual-Port (Read and Write) Functionality, Attorney Docket No. 37364/B600/JFO; Memory Redundancy Implementation, Attorney Docket No. 37496/B600/JFO; and; A Circuit Technique for High Speed Low Power Data Transfer Bus, Attorney Docket No. 37497/B600/JFO.

### BACKGROUND OF THE INVENTION

### I Field of the Invention

The present invention relates to memory devices, in particular, semiconductor memory devices, and most particularly, scalable, power-efficient semiconductor memory devices.

### 2. Background of the Art

Memory structures have become integral parts of modem VLSI systems, including digital signal processing systems. Although it typically is desirable to incorporate as many memory cells as possible into a given area, memory cell density is usually constrained by other design factors such as layout efficiency, performance, power requirements, and noise sensitivity.

In view of the trends toward compact, high-performance, high-bandwidth integrated computer networks, portable computing, and mobile communications, the aforementioned constraints can impose severe limitations upon memory structure designs, which traditional memory system and subcomponent implementations may fail to obviate.

One type of basic storage element is the static random access memory (SRAM), which can retain its memory state without the need for refreshing as long as power is applied to the cell.

In an SRAM device, the memory state II usually stored as a voltage differential within a bistable fimetional element, such as an inverter loop. A SRAM cell is more complex than a counterpart dynamic RAM (DRAM) cell, requiring a greater number of constituent elements, preferably transistors. Accordingly, SRAM devices commonly consume more power and dissipate more heat than a DRAM of comparable memory density, thus efficient; lower- power SRAM device designs are particularly suitable for VLSI systems having need for high- density SRAM I components, providing those memory components observe the often strict overall design constraints of the particular VLSI system. Furthermore, the SRAM subsystems of many VLSI systems frequently are integrated relative to particular design implementations, with specific adaptions of the SRAM subsystem limiting, or even precluding, the scalability of the SRAM subsystem design. As a result SRAM memory subsystem designs, even those considered to be 64 scalable", often fail to meet design limitations once these memory subsystem designs are scaled up for use in a VLSI system with need for a greater memory cell population and/or density.

There is a need for an efficient, scalable, high-performance, low-power memory structure that allows a system designer to create a SRAM memory subsystem that satisfies strict constraints for device area, power, performance, noise sensitivity, and the like.

US 5,734,616 describes a static RAM including pre-amplifiers, which are made up of emitter-follower transistors having their collectors supplied with the power voltage, in one-to-one correspondence to sub common data line pairs which are connected by column switches to complementary data line pairs of memory arrays. The pre-amplifier is provided with a first switch which turns on during the selected state to connect the sub common data line pair to the bases of the transistors and a second switch which turns on during the unselected state to provide the bases with a certain bias voltage lower than the readout signal voltage on the sub common data line pair.

US 6,009,024 describes semiconductor memory including a plurality of memory cells, a pair of local bit lines connected to the plurality of memory cells, a local sense amplifier for amplifying a potential difference between the pair of local bit lines, a pair of global bit lines electrically connected to the pair of local bit lines through a switch, and a global sense amplifier for amplifying a potential difference between the pair of global bit lines.

US 4,984,202 describes a large-scale semiconductor integrated circuit comprising a low voltage-operated CMOS internal circuit, input and output circuits having bipolar transistors, said low voltage-operated CMOS internal circuit being supplied with an internal power supply voltage which is produced by dropping an external power supply voltage, and a level shifting circuit which converts the levels of signals in the chip.

According to the invention, there is provided a memory module as defined by independent claim 1.

Further advantageous features of the invention are defined by the dependent subclaims.

The present invention satisfies the above needs by providing a memory module with hierarchical functionality. The present invention further provides a hierarchical memory structure composed of such memory modules. The memory module itself can be tiered and hierarchical, such that a "global" device in a particular tier can be classified as a "local" device relative to an immediately superior tier in the hierarchy; conversely, a "local" device in the same particular tier can be classified as a "global" device relative to an immediately inferior tier in the hierarchy.

In the fundamental, or first tier, a memory module can have one or more memory cells, which are coupled with a local sense amplifier. One or more local sense amplifiers can be coupled with a global sense amplifier, forming a column-oriented memory structure. A memory state signal is received from the memory by the local sense amplifier which, in turn, provides a local memory state signal to the global sense amplifier. The global sense amplifier can receive this local memory state signal and provide a global memory state signal in response. Multiple column structures can be grouped to form a two-dimensional memory array for a given tier. In successively superior tiers, a memory module can have one or more constituent memory modules arranged of an inferior tier. Groups of constituent memory modules can be selectively coupled with local sense amplifiers, that, in turn, are coupled with a global sense amplifier, which can provide a signal corresponding to a memory location to either the next superior tier or, if disposed in the uppermost tier of the hierarchy, to the memory structure 1/0 buffers.

Also in the first tier, the one or more cells in the memory module can be coupled with a local wordline, or row, decoder. One or more local wordline decoders can be coupled with a global wordline, forming a row-oriented memory structure. A global wordline decoder receives a global selection signal corresponding to selected memory cells and provides this signal to local wordline decoders. The local wordline decoders receive this signal and provide a local selection signal which activates the selected memory cells. As with the columnar structures, multiple rows can be grouped to form a two-dimensional memory array for a given tier. In successively superior tiers, a memory module can have one or more constituent memory modules of an I inferior tier. Groups of constituent memory modules can be selectively coupled with local wordline decoders, that, in turn, are coupled with a global wordline decoders, which can receive a selection signal corresponding to a memory location from either the next superior tier or, if disposed in the uppermost tier of the hierarchy, from the predecoder/wordline drivers driven by the address inputs.

Limited voltage swing signals can be provided by the memory cells, local sense amplifiers, global sense amplifiers, local wordline decoders, global wordline decoders, or combinations thereof. Where memory cells produce limited voltage swing signals, the corresponding local sense amplifier also is responsive to such signal. It is preferred to employ limited voltage swing signals wherever in order to minimize the power consumption and maximize the operating speed of the memory module, and memory structures composed thereof. To this end, one aspect of the present invention includes a single-ended sense amplifier having sample- and-hold reference. In another aspect of the present invention, a charge-share limited-swing- driver sense amplifier is employed. In addition to limiting voltage swings, it also is desirable to isolate synchronous circuits, such as predecoders, and clocked word line decoders, from asynchronous circuits, such as local word line decoders. Thus, another aspect of the present invention provides an asynchronously-resettable row decoder.

Because it is desirable to control signal voltage duration and decay, thereby constraining limited voltage swing signals, devices that accurately terminate a signal are provided, including a high-precision delay measurement circuit, and a diffusion replica delay circuit. The high precision delay measurement circuit can provide exceptionally accurate time measurement, for example, a half-gate delay. The high-precision delay measurement circuit can be realized with a multi-stage ring oscillator that can be coupled with multiple oscillation signal detectors, which can be counters and signal edge detection circuits, which respectively count the number of oscillations by the circuit, and determine the extent to which a particular oscillation signal propagated within the oscillator.

The diffusion replica delay circuit constrains the limited voltage swing signal by substantially replicating a delay characteristic of a predetermined memory structure component, for example, a bitline, so that a localized timing signal can be generated, thus providing high localized decision making, e.g., permitting independent operation of, and access to, memory structure rows. One embodiment of this aspect of the invention includes a diffusion capacitance, which is generally matched to the total capacitance of the associated structure (e.g., bitline), and a transistor, which is generally replicates the aggregate characteristics of the transistors, if any, used to access the associated structure. Another embodiment of this aspect of the invention can include dummy cells operably coupled with a selected wordline decoder and a selected sense amplifier. Also, a split dummy bitline can be associated with a particular wordline, obviating the excess delay from grouped wordline association. In a further aspect of the present invention, a data transfer bus circuit is provided to employ a limited, controlled voltage swing on a data bus PCT[US01/03342 I with which the various components of the present invention may be coupled. Additionally, the data transfer bus circuit can include a programmable driver capable of imposing logic signals on the data bus, including encoded signals, multilevel logic signals, or both. Moreover, a bidirectional data transfer bus circuit also is provided.

In order to provide robust high-yield memory structures, particularly in embedded contexts, several redundancy devices are provided. In one embodiment of the redundancy aspect of the present invention, a redundant group of memory cells and a redundancy controller are provided. The redundancy controller replaces a designated memory group with the redundant group, in response to a memory condition, typically an inoperable or "FAILED" memory group.

The redundant memory group can be a memory row, a memory column, a preselected portion of a memory module, a selectable portion of a memory module, a memory module, and a combination thereof. This embodiment ofredundancy can be implemented during manufacturing, for example, using fuses and decoders; or can be implemented dynamically in-the-field, for example, using programmable switches. Redundancy can be implemented in other ways, as well.

In yet another embodiment of redundancy according to the present invention, a wordline decoder having row redundancy is provided. The wordline decoder can be coupled with two memory rows. During typical operation the wordline decoder selects and decodes the first memory row.

However, responsive to an alternative-row-select signal, for example, resulting from a row failure, the wordline decoder is selects and decodes the second memory row, instead. In still another embodiment of the redundancy aspect of the invention herein, the aforementioned asynchronously-resettable row decoder can be modified to include row redundancy, as above.

The memory module and hierarchical memory structure according to the present invention can be disposed in a semiconductor device, an optical device, and a combination thereof, for example, within a communication device.

The present invention also includes a method obtaining dual-port functionality from a single-port hierarchical memory structure. One aspect of this embodiment entails a WRITE AFTER-READ operation without a separate PRECHARGE cycle interposed between the READ and WRITE cycles, with the entire WRITE-AFTER-READ operation being completed within one memory access cycle of the hierarchical memory structure. Where a first datum is to be retrieved from a first memory location and a second datum is to be stored in a second memory location, the method includes locally selecting the first memory location from which the first datum is to be retrieved; locally sensing the first datum (i.e., the READ operation); globally selecting the second memory location; substantially concurrently with the globally selecting, globally sensing the first datum at the first memory location; outputting the first data subsequent to the globally sensing; inputting the second datum substantially immediately subsequent to the outputting the first datum; locally selecting the second memory location; and storing the second datum (i.e., WRITE operation). Where necessary, precharging the requisite bitlines may be performed, prior to locally sensing the first datum (i.e., PRECHARGE operation). Due to the I efficiencies realized by a hierarchical memory structure according to the present invention, including the elimination of a second PRECHARGE operation immediately prior to the WRITE operation, such PRECHARGE/READ/WRITE operation can be accomplished in less than a single memory access cycle of the hierarchical memory structure. Indeed, where the context of the overall hierarchical memory structure (e.g., long interconnect lines, large overall memory structure, etc.) permits, multiple PRECHARGE/READ/WRITE operations can be accomplished in less than one memory access cycle. In another embodiment of this method, a WRITE-AFTER WRITE operation can be accomplished by interposing a PRECHARGE operation between subsequent WRITE operations. This embodiment of the inventive method herein includes globally selecting the first memory location to which the first datum is to be stored; precharging bitlines coupled with the first memory location (PRECHARGE 1 operation); locally selecting the first memory location; storing the first datum (WRITE I operation); globally selecting the second memory location to which the second datum is to be stored; substantially concurrently with the globally selecting of the second memory location, precharging bitlines coupled with the second memory location (PRECHARGE2 operation); locally selecting the second memory location; and storing the second datum (WRITE2 operation). Despite the intervening PRECHARGE2 operation, the efficiencies afforded by a hierarchical memory structure according to the present invention nevertheless permit one or more WRITE-AFTER-WRITE operations to be performed within in less than a single memory access cycle of the hierarchical memory structure.

Advantageously the memory module further comprises a global sense amplifier, coupled with the local sense amplifier, the global sense amplifier sensing the local memory state signal and producing a global memory state signal representative thereof.

Advantageously the memory module further comprises a plurality of memory cells coupled with the local sense amplifier.

Advantageously the memory module further comprises
a. a plurality of local sense amplifiers wherein the sense amplifier is coupled with the plurality of local sense amplifiers, a selected one of the plurality of local sense amplifiers sensing the memory state and producing a local memory state signal representative thereof, the global sense amplifier sensing the local memory state signal and producing a global memory state signal representative thereof, and wherein the plurality of memory cells coupled with the global sense amplifier is disposed as a memory column.

Advantageously the plurality of memory cells comprises a memory cell subcolumn, and the local sense amplifier is coupled with a single memory cell subcolumn.

Advantageously the plurality of memory cells is partitioned to form a plurality of memory cell subcolumns each having a respective plurality of memory cells, and the local sense amplifier is coupled with the plurality of memory cell subcolumns.

Advantageously the memory module further comprises a plurality of global sense amplifiers, selected ones of the plurality of global sense amplifiers having a respective plurality of local sense amplifiers coupled therewith, and selected ones of the plurality of local sense amplifiers being coupled with a respective plurality of memory cells, selected others of the plurality of global sense amplifiers being coupled with the selected ones such that the selected ones of the plurality of global sense amplifiers are local sense amplifiers relative to the selected others of the plurality of global sense amplifiers, each local sense amplifier producing a respective local memory state signal to which a corresponding global sense amplifier is responsive.

Advantageously at least three of the local memory state signal, global memory state signal, local decoder selection signal and global selection signal comprise a limited swing voltage signal.

Advantageously each of the local memory state signal, global memory state signal, local decoder selection signal and global selection signal comprises a limited swing voltage signal.

Advantageously the global sense amplifier produces a limited swing voltage signal representative of the memory state.

Advantageously one of the local sense amplifier is responsive to a limited swing voltage signal from the memory cell representative of the memory state.

Advantageously one of the local memory state signal and the global memory state signal is a limited swing voltage signal.

Advantageously both of the local memory state signal and the global memory state signal is a limited swing voltage signal.

Advantageously the memory module further comprises a local wordline decoder coupled with the memory cell, the local wordline decoder selecting the memory cell responsive to a local selection signal.

Advantageously the memory module further comprises a local wordline decoder coupled with the memory cell, the local wordline decoder selecting the memory cell responsive to a local selection signal.

Advantageously the memory module further comprises a global wordline decoder coupled with the local wordline decoder, the global wordline decoder producing the local selection signal responsive to a global selection signal.

Advantageously the memory module further comprises a plurality of local wordline decoders coupled with respective memory cells, a selected one of the plurality of local word-line decoders selecting one of the respective memory cells responsive to a local selection signal.

Advantageously the global wordline decoder coupled with the plurality of local wordline decoders, the global wordline decoder producing the local decoder selection signal responsive to the global selection signal, and wherein the plurality of memory cells coupled with the global wordline decoder is disposed as a memory row.

Advantageously the memory module further comprises a plurality of local wordline decoders coupled with respective memory cells, selected ones of the plurality of local word-line decoders selecting respective memory cells responsive to a corresponding local decoder selection signal.

Advantageously the memory module further comprises a global wordline decoder coupled with the plurality of local wordline decoders, the global wordline decoder producing the local decoder selection signal responsive to a global selection signal, and wherein the plurality of memory cells coupled with the global wordline decoder is disposed as a memory row.

Advantageously the memory module further comprises a plurality of global wordline decoders, selected ones of the plurality of global wordline decoders being coupled with a respective plurality of local wordline decoders, selected ones of the plurality of local wordline decoders being coupled with a respective plurality of memory cells, selected others of the plurality of global wordline decoders being coupled with the selected ones such that the selected ones are local wordline decoders relative to the selected others, each global wordline decoder producing a respective global selection signal to which the corresponding plurality of local wordline decoders is responsive.

Advantageously one of the local memory state signal, the global memory state signal, the local selection signal, the global selection signal, and a combination thereof, comprises a limited swing voltage signal.

Advantageously at least one of the global sense amplifier and the plurality of local sense amplifiers comprises one of a single-ended sense amplifier having sample-and-hold reference, and a charge-share limited-swing-driver sense amplifier.

Advantageously the memory module further comprises a wordline decoder having a first memory row and a second memory row coupled therewith, the wordline decoder decoding the first memory row, and being disposed to select and decode the second memory row responsive to an alternative-row-select signal.

Advantageously the memory module further comprises:
a. a redundant memory row; and
b. a wordline decoder coupled an assigned memory row and the redundant memory row, the row decoder decoding the assigned memory row, and being disposed to select and decode the redundant memory row responsive to a redundant-row- select signal.

Advantageously one of the plurality of global wordline decoders and local wordline decoders comprises an asynchronously- resettable row decoder.

Advantageously the asynchronously-resettable row decoder has a first memory row and a second memory row coupled therewith, the row decoder decoding the first memory row, and being disposed to select and decode the second memory row responsive to an alternative-row-select signal.

Advantageously the memory module has a designated group of memory cells assigned to represent a logical portion of the memory structure, the structure further comprising:
a. a redundant group of memory cells; and
b. a redundancy controller coupled with the designated group and the redundant group, the redundancy controller assigning the redundant group to the logical portion of the memory structure, responsive to a preselected memory group condition.

Advantageously the redundancy controller comprises a redundancy decoder responsive to an encoded signal representative of the preselected memory group condition.

Advantageously the redundancy controller further comprises a plurality of selectable switches, the plurality of selectable switches encoding the preselected memory group condition.

Advantageously the plurality of selectable switches are fuses.

Advantageously the preselected memory group condition is a "FAILED" memory group condition, representative of a designated group malftinction.

Advantageously each of the designated group and the redundant group comprises one of a memory row, a memory column, a preselected portion of a memory module, a selectable portion of a memory module, a memory module, and a combination thereof.

Advantageously the wordline decoder includes a selection signal input, and further comprises a multiplexer operably coupled with the first memory row and the second memory row, the multiplexer selectably directing the local selection signal from the wordline decoder selection signal input to the selected one of the first memory row and the second memory row.

Advantageously the local sense amplifier comprises a high precision delay measurement circuit.

Advantageously the memory module further comprises a high-precision delay measurement circuit constraining the limited swing voltage signal.

Advantageously the high-precision delay measurement circuit comprises a ring oscillator executing oscillation cycle in a predefined oscillation period.

Advantageously the ring oscillator executes a plurality of oscillation cycles by circulating an oscillation signal therein, and the ring oscillator comprises:
a. a plurality of oscillator stages; and b. a plurality of oscillation signal detectors interposed between selected ones of the oscillator stages, the plurality of oscillation signal detectors detecting the location of the oscillation signal within the ring oscillator during a measured oscillation cycle, responsive to a measurement signal.

Advantageously the high-precision delay measurement circuit further comprises a counter coupled with the ring oscillator, an oscillator cycle incrementing the counter, and the counter measuring cardinality of the plurality of oscillation cycles thereby.

Advantageously the oscillation signal has alternating positive signal edges and negative signal edges on successive ones of the plurality of oscillation cycles, and wherein the high-precision delay measurement circuit further comprises a positive edge counter and a negative edge counter, each of the positive edge counter and the negative edge counter measuring cardinality of the plurality of oscillation cycles.

Advantageously the plurality of oscillation counters comprise a dual-edge detection counter.

Advantageously the memory module further comprises a high-precision delay measurement circuit constraining the limited swing voltage signal.

Advantageously the high-precision delay measurement circuit comprises a ring oscillator executing oscillation cycle in a predefted oscillation period.

Advantageously the ring oscillator executes a plurality of oscillation cycles by circulating an oscillation signal therein, and the ring oscillator comprises:
a. a plurality of oscillator stages; and b. a plurality of oscillation signal detectors interposed between selected ones of the oscillator stages, the plurality of oscillation signal detectors detecting the location of the oscillation signal within the ring oscillator during a measured oscillation cycle, responsive to a measurement signal.

Advantageously the high-precision delay measurement circuit further comprises a counter coupled with the ring oscillator, an oscillator cycle incrementing the counter, and the counter measuring cardinality of the plurality of oscillation cycles thereby.

Advantageously the oscillation signal has alternating positive signal edges and negative signal edges on successive ones of the plurality of oscillation cycles, and wherein the high-precision delay measurement circuit further comprises a I positive edge counter and a negative edge counter, each of the positive edge counter and the negative edge counter measuring cardinality of the plurality of oscillation cycles.

Advantageously the plurality of oscillation counters comprise a dual-edge detection counter.

Advantageously the diffusion replica delay circuit comprises dummy cells operably coupled with a selected wordline decoder and a selected sense amplifier.

Advantageously wherein the dummy cells comprise split dummy bit lines.

Advantageously the memory module further comprises a data transfer bus circuit coupling the global sense amplifier to a data bus.

Advantageously wherein the data transfer bus circuit comprises a programmable driver, the programmable driver capable of imposing multilevel logic signals on the data bus.

Advantageously the memory module further comprises a data transfer bus circuit coupling a selected one of the pluralities of global sense amplifiers, local sense amplifiers, global wordline decoders, and local wordline decoders to a data bus, the circuit imposing a limited voltage swing on the data bus.

Advantageously the data transfer bus circuit comprises a programmable driver programmed to impose logic signals on the data bus.

Advantageously the programmable driver is programmed to impose encoded signals on the data bus.

Advantageously the programmable driver is programmed to impose multilevel logic signals on the data bus.

Advantageously one of the pluralities of global sense amplifiers, local sense amplifiers, global wordline decoders, and local wordline decoders comprises a limited swing voltage circuit, the limited swing voltage circuit producing a limited swing voltage signal of a respective one of the global memory state signal, the local memory state signal, and the global selection signal, the local decoder selection signal.

Advantageously the memory module is disposed in one of a semiconductor device, an optical device, and a combination thereof.

Advantageously the memory module is embedded in a communication device.

Advantageously the memory module is disposed in one of a semiconductor device, an optical device, and a combination thereof.

Advantageously the memory module is embedded in a communication device.

The present invention will be more fully understood from the following detailed description of the embodiments thereof, taken together with the following drawings.

### BRIEF DESCRIPTION OF THE DRAWINGS

These and other features, aspects and advantages of the present invention will be more fully understood when considered with respect to the following detailed description, appended claims and accompanying drawings, wherein:

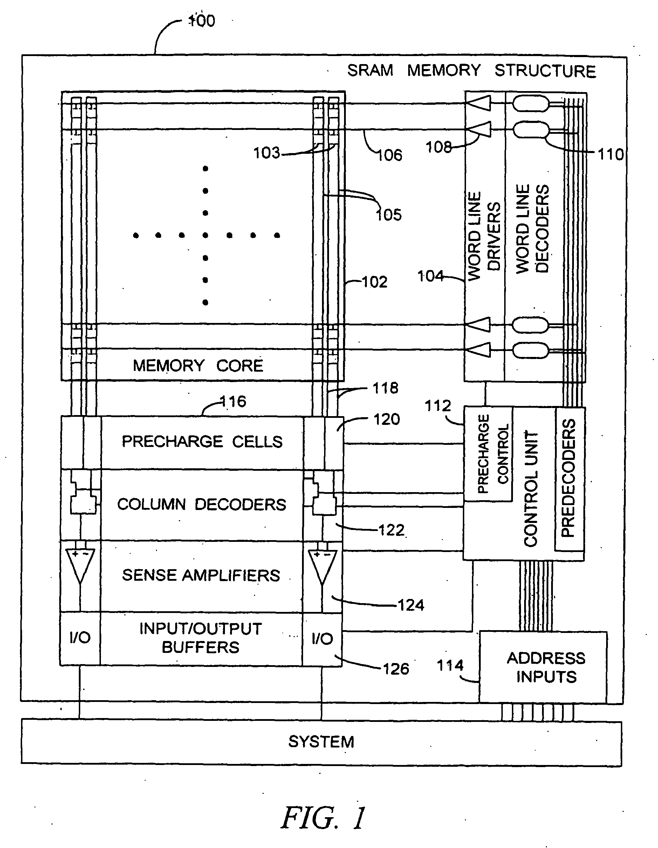

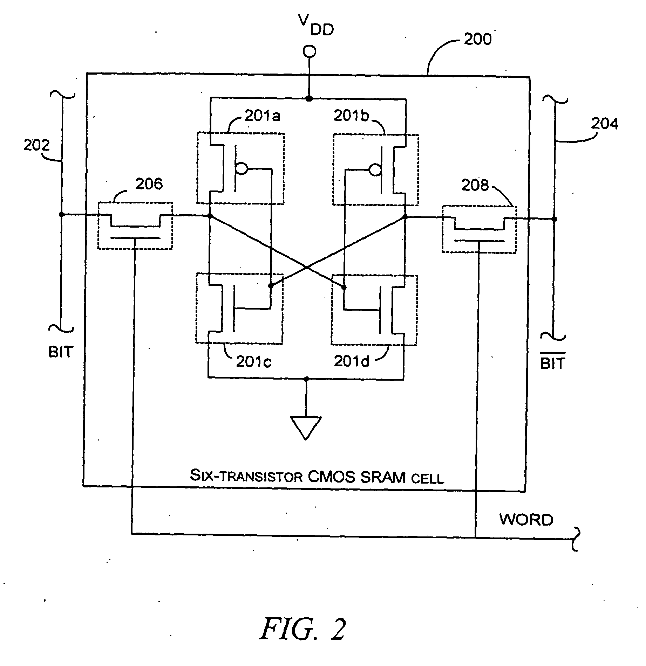

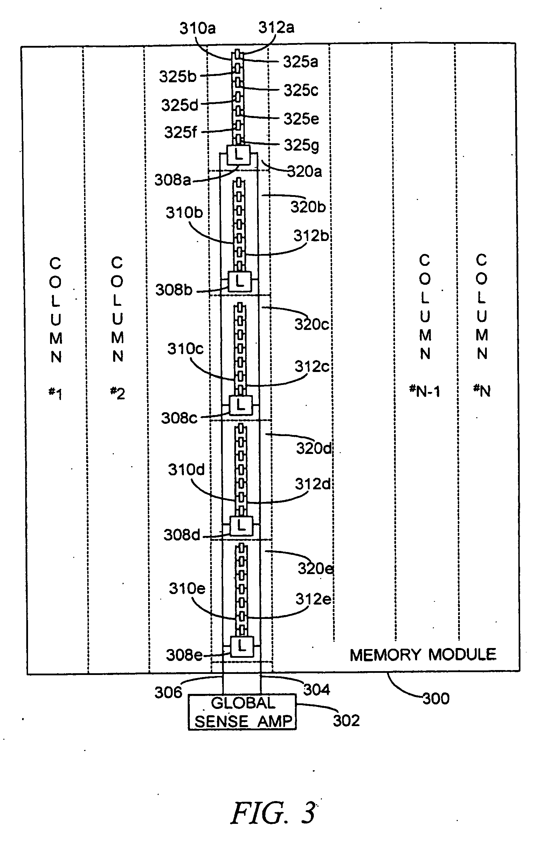

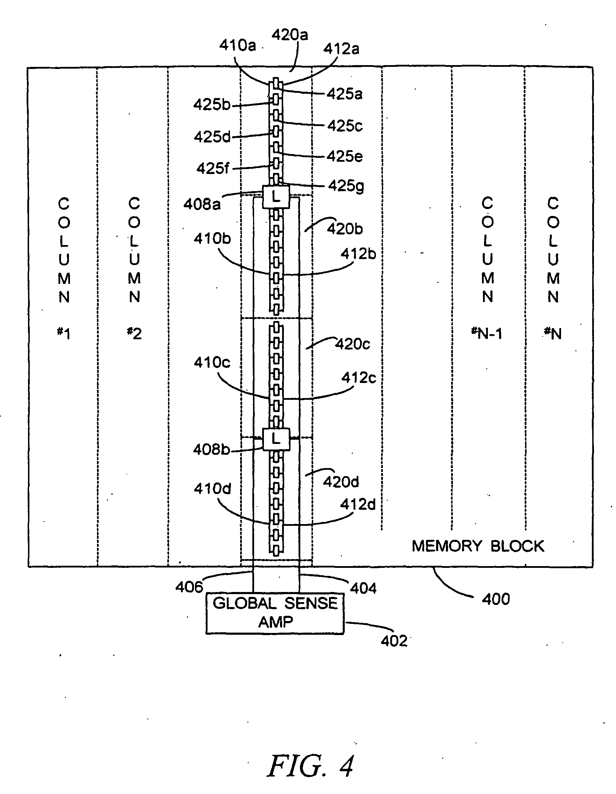

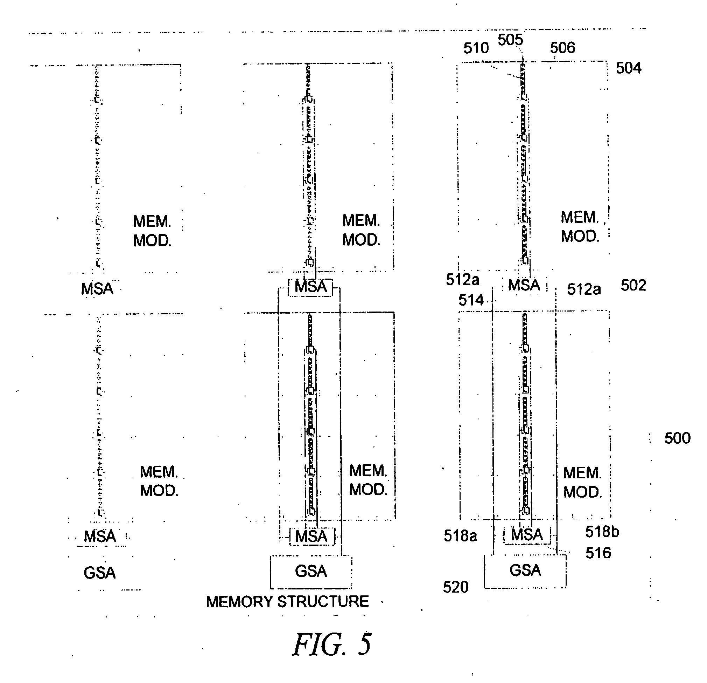

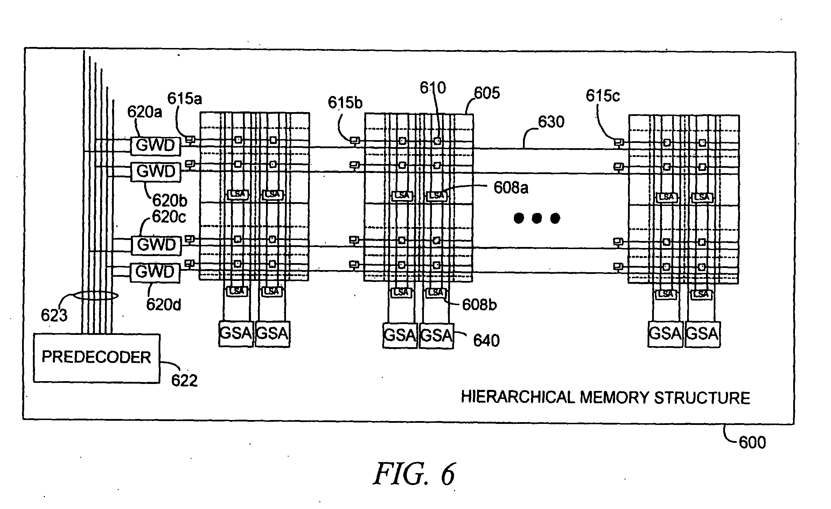

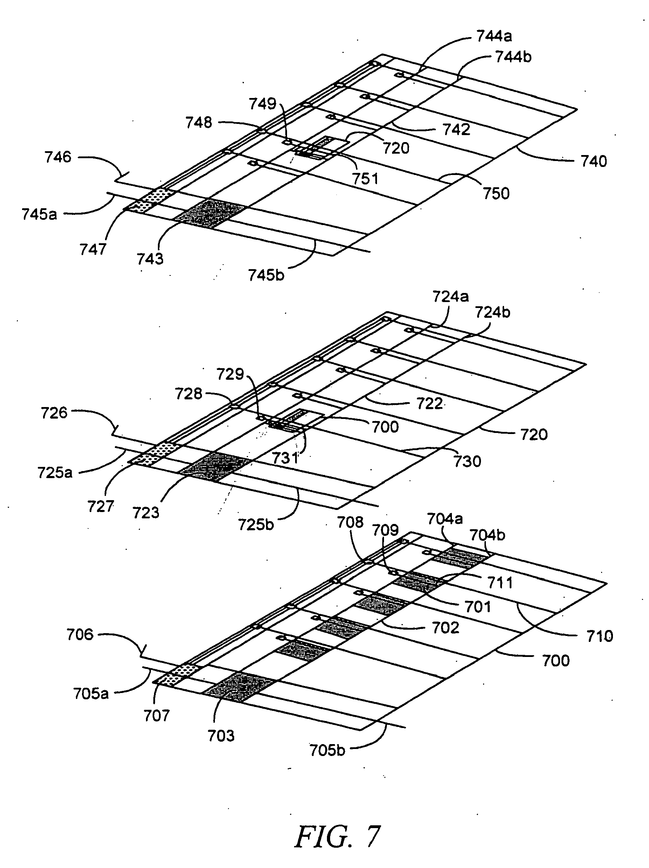

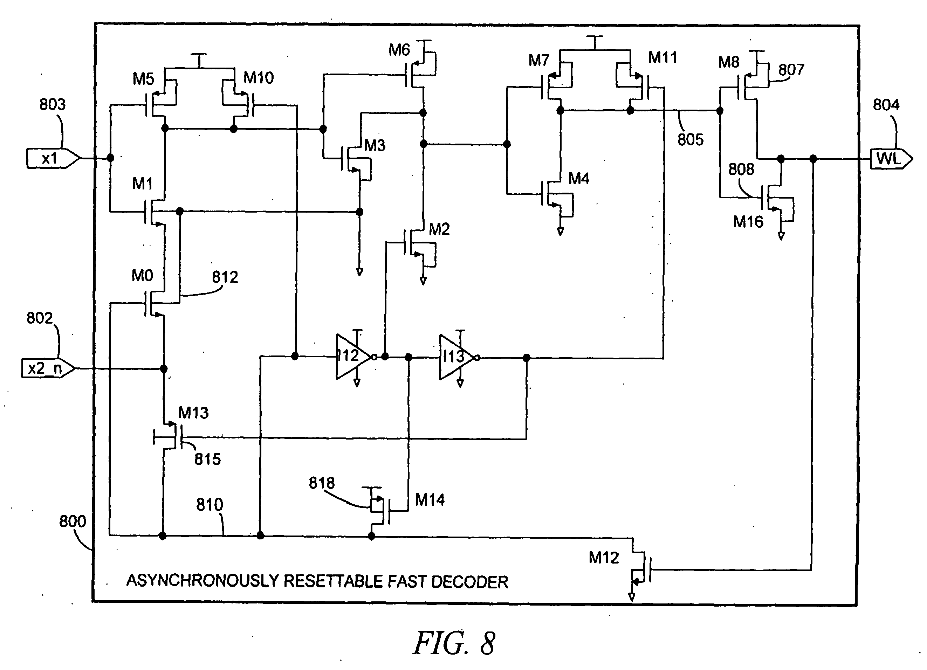

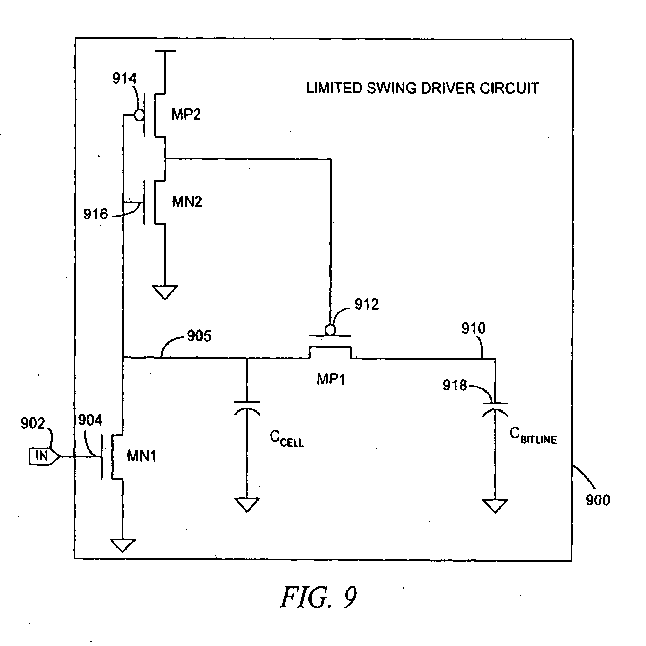

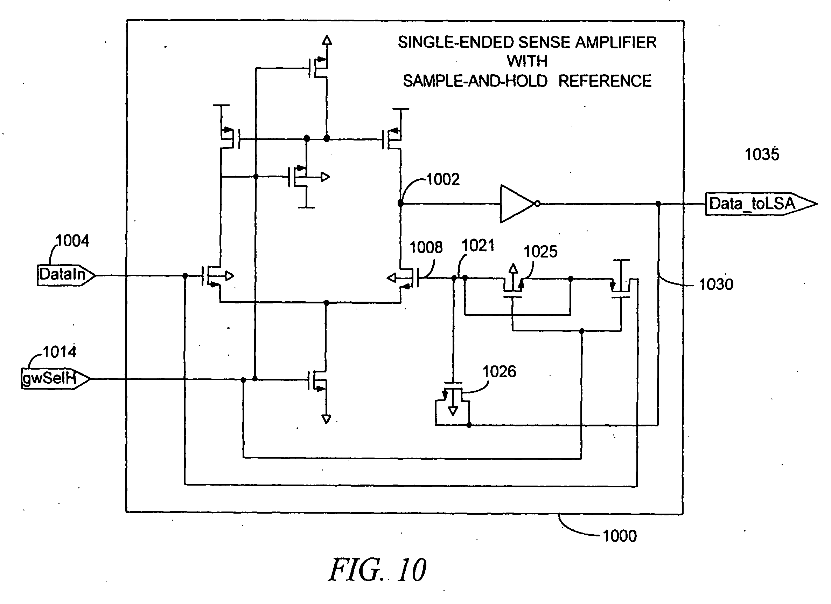

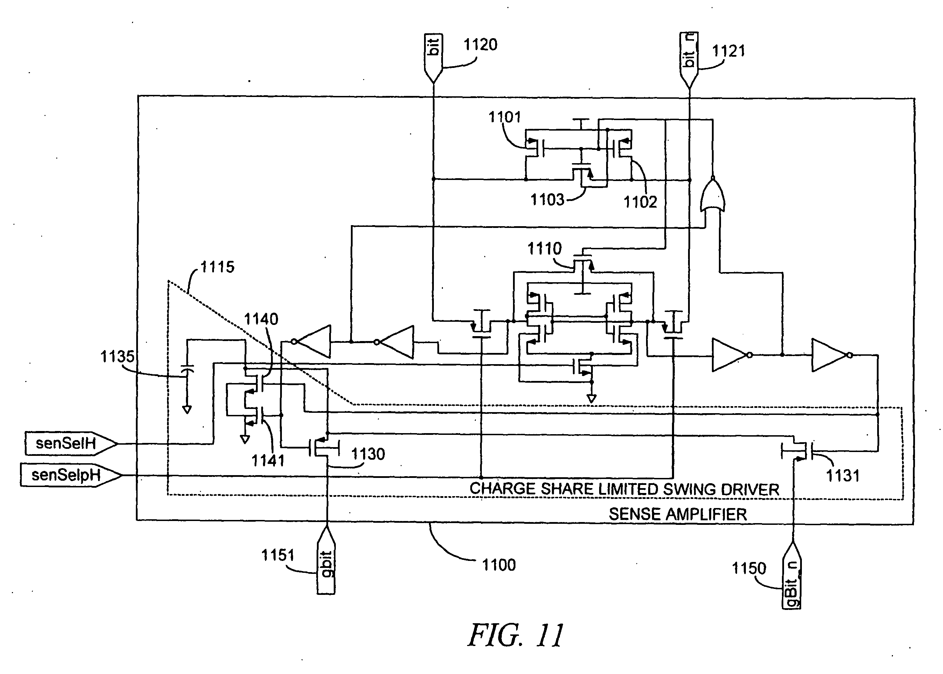

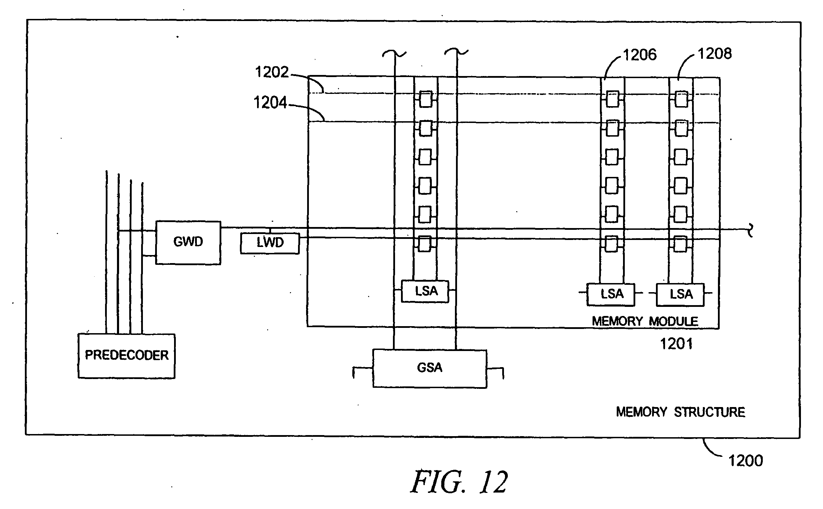

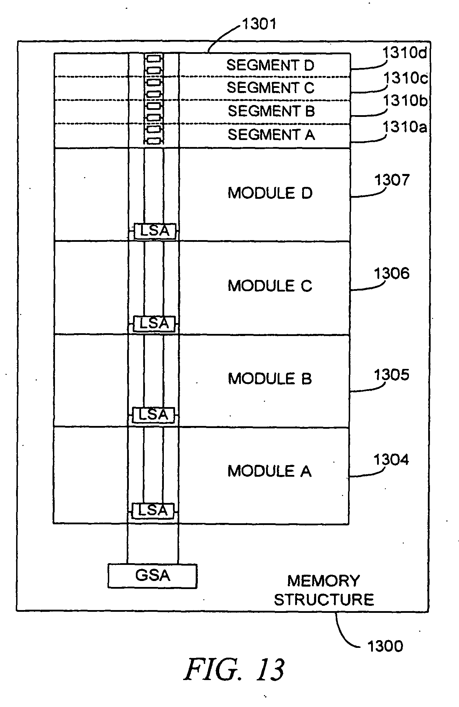

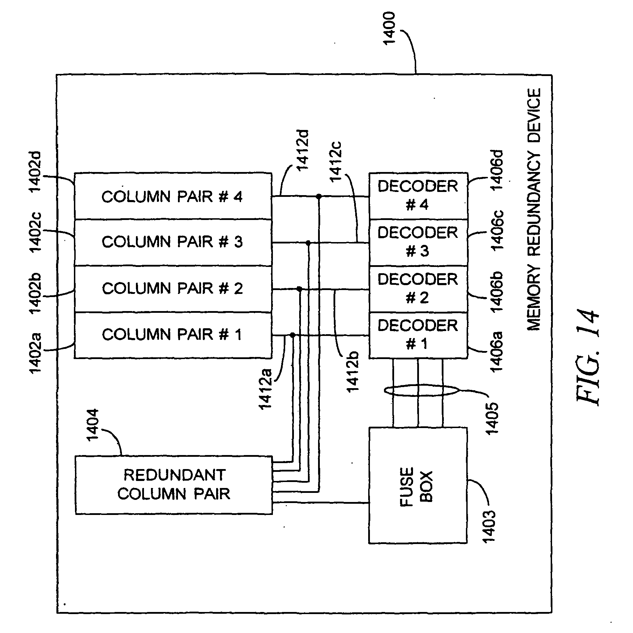

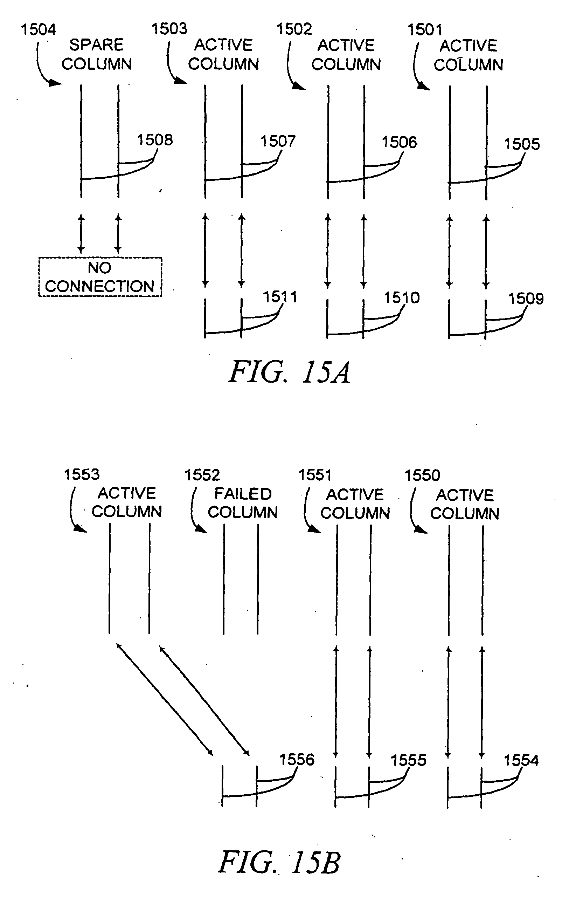

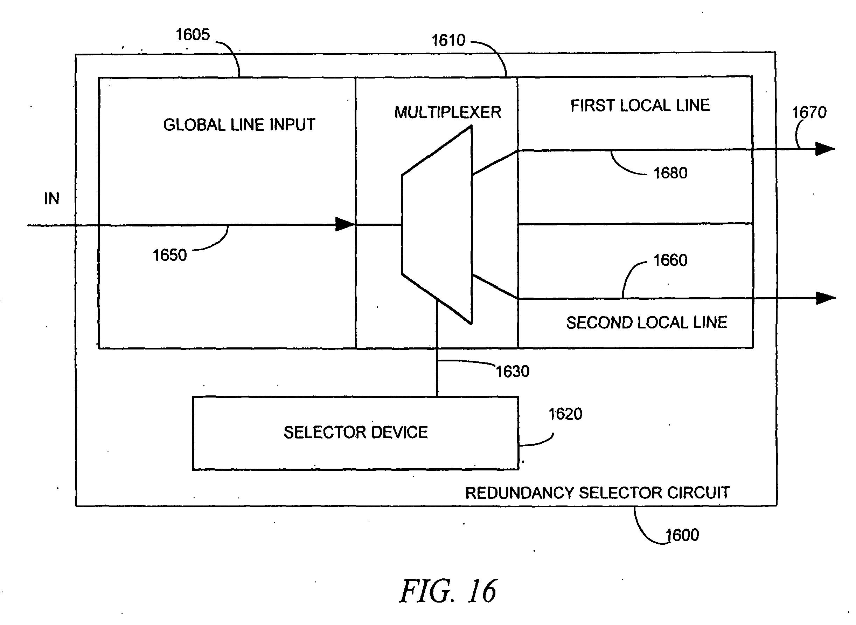

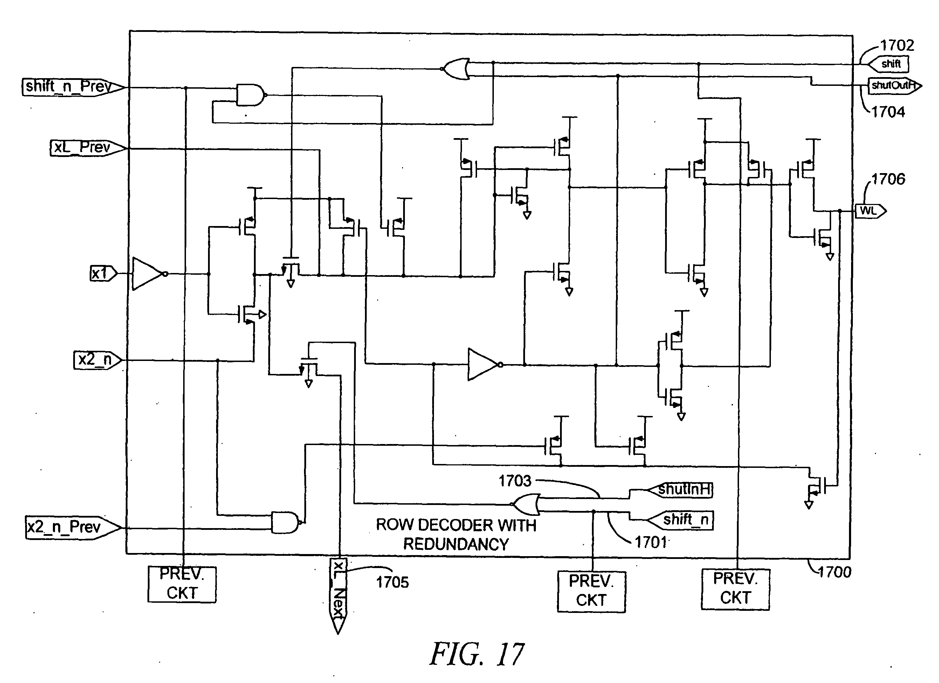

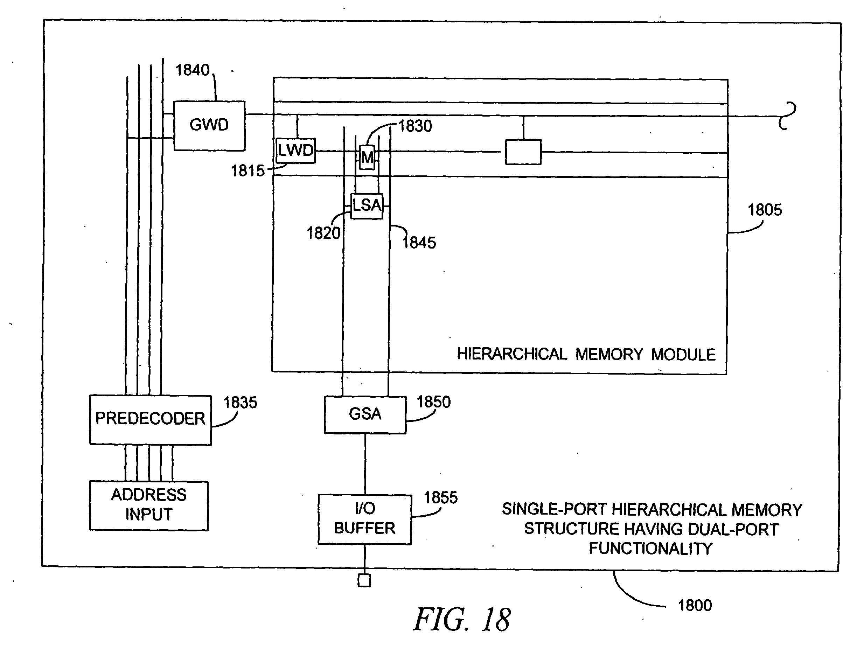

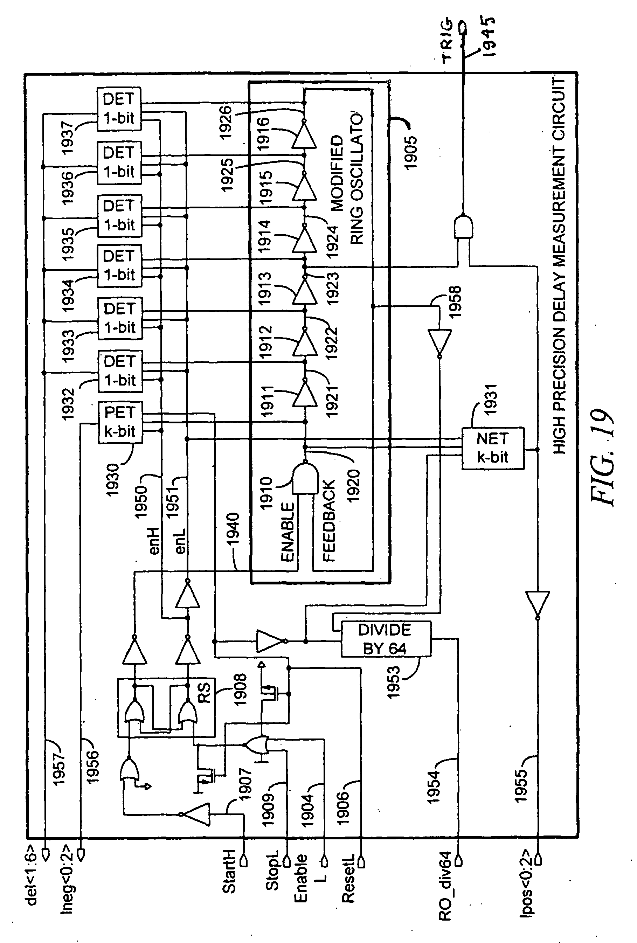

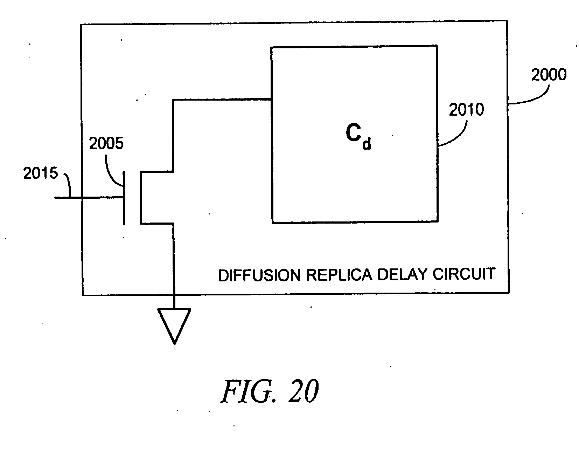

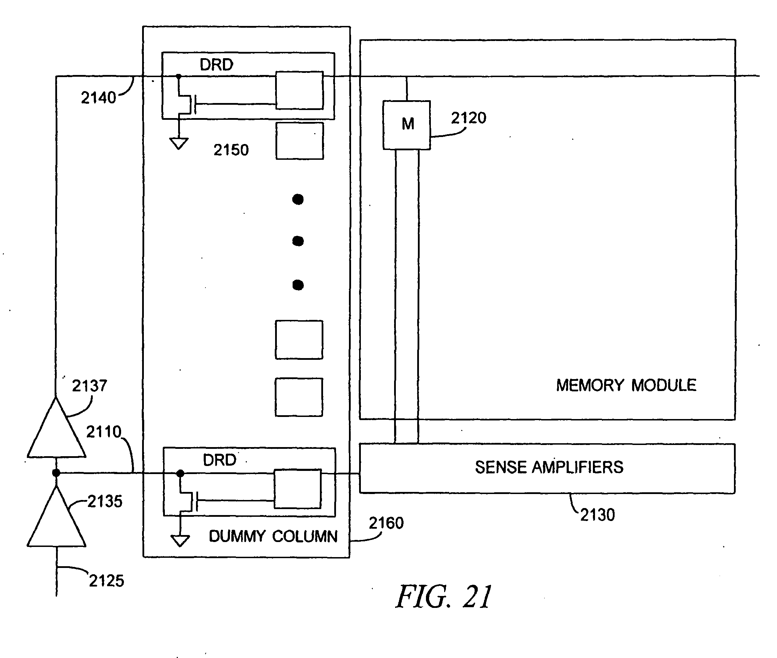

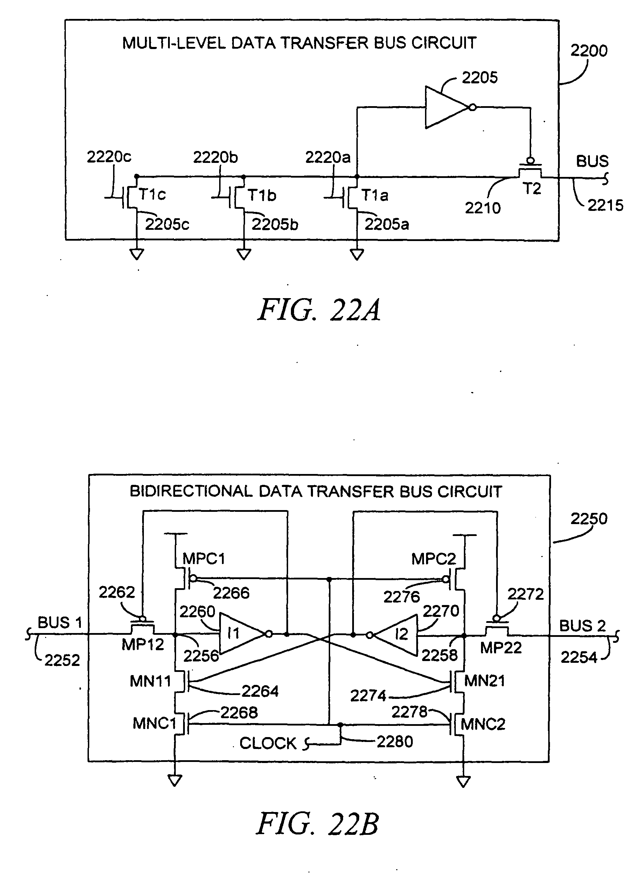

FIG. 1 is a block diagram of an exemplary static random access memory (SRAM) architecture; FIG. 2 is a general circuit schematic of an exemplary six-transistor CMOS SRAM memory cell; FIG. 3 is a block diagram of an embodiment of a hierarchical memory module using local bitline sensing, according to the present invention; FIG. 4 is a block diagram of an embodiment of a hierarchical memory module using an alternative local bitline sensing structure; FIG. 5 is a block diagram of an exemplary two-dimensional, two-tier hierarchical memory structure, employing plural local bitline sensing modules of FIG.3; FIG. 6 is a block diagram of an exemplary hierarchical memory structure depicting a memory module employing both local word line decoding and local bitline sensing structures; I FIG. 7 is a perspective illustration of a hierarchical memory structure having a three-tier hierarchy, in accordance with the invention herein; FIG. 8 is a circuit schematic of an asynchronously-resettable decoder, according to an aspect of the present invention; FIG. 9 is a circuit schematic of a limited swing driver circuit, according to an aspect of the present invention; FIG. 10 is a circuit schematic of a single-ended sense amplifier circuit with sample-and- hold reference, according to an aspect of the present invention; FIG. 11 is a circuit schematic of charge-share, limited-swing driver sense amplifier circuit, according to an aspect of the present invention; FIG. 12 is a block diagram illustrating an embodiment of hierarchical memory module redundancy; FIG. 13 is a block diagram illustrating another embodiment of hierarchical memory module redundancy; FIG. 14 is a block diagram of a memory redundancy device, illustrating yet another embodiment of hierarchical memory module redundancy; FIG. 15A is a diagrammatic representation of the signal flow of an exemplary unfaulted memory module featuring column-oriented redundancy; FIG. 15B is a diagrammatic representation of the shifted signal flow of the exemplary faulted memory module illustrated in FIG. 15A; FIG. 16 is a generalized block diagram of a redundancy selector circuit, illustrating still another embodiment of hierarchical memory module redundancy; FIG. 17 is a circuit schematic of an embodiment of a global row decoder having row redundancy according to the invention herein; FIG. 18 is a block diagram illustrating dual-port functionality in a single-port hierarchical memory structure employing hierarchical memory modules according to the present invention; FIG. 19 is a schematic diagram of one embodiment of a high precision delay measurement circuit, according to the present invention; FIG. 20 is a simplified block diagram of one aspect of the present invention employing one embodiment of a diffusion replica delay circuit; FIG. 21 is a simplified block diagram of one aspect of the present invention employing another embodiment of a diffusion replica delay circuit; FIG. 22A is a schematic diagram of another aspect of an embodiment of the present invention, employing a high-speed, low-power data transfer bus circuit; and FIG. 22B is a schematic diagram of another aspect of an embodiment of the present invention, employing a high-speed, low-power data transfer bus circuit.

### DETAILED DESCRIPTION OF THE EMBODIMENTS

As will be understood by one having skill in the art, most VLSI systems, including communications systems and DSP devices contain VLSI memory subsystems. Modem applications of VLSI memory subsystems almost invariably demand high efficiency, high performance implementations that magnify the design tradeoff between layout efficient, speed, power consumption, scalability, design tolerances, and the like. The present invention ameliorates these tradeoffs using a novel hierarchical architecture. The memory module of the present invention also can employ one or more novel components which finther add to the memory modules efficiency and robustness.

Hereafter, but solely for the purposes of exposition, it will be useftil to describe the various aspects and embodiments of the invention herein in the context of an SRAM memory structure, using CMOS SRAM memory cells. However, it will be appreciated by those skilled in the art the present invention is not limited to CMOS-based processes and that, mutatis mutandi, these aspects and embodiments may be used in categories of memory products other than SRAM, including without limitation, DRAM, ROM, PLA, and the like, whether embedded within a VLSI system, or a stand alone memory device.

EXEMPLARY SRAM MODULE AND STORAGE CELL Figure 1 is a functional block diagram of SRAM memory structure 100 that illustrates the basic features of most SRAM subsystems. Module 100 includes memory core 102, word line controller 104, precharge controller 112, memory address inputs 114, and bitline controller 116.

Memory core 102 is composed of a two-dimensional array of K-bits of memory cells 103, which is arranged to have C columns and R rows of bit storage locations, where K = 0 x R). The most common configuration of memory core 102 uses single word line 106 to connect cells 103 onto paired differential bitlines 118. In general, core 102 is arranged as an array of 2P word lines, based on a set of P memory address input lines 114 i.e., R = 2P. Thus, the p-bit address is decoded by row address decoder I 10 and column address decoder 122. Access to a given memory cell 103 within such a single-core memory is accomplished by activating the column 105 and the row 106 corresponding to cell 103. Column 105 is activated by selecting, and switching, all bitlines in the particular column corresponding to cell 103.

The particular row to be accessed is chosen by selective activation of row address decoder I 10, which usually corresponds uniquely with a given row, or word line, spanning all cells 103 on the particular row. Also, word driver 108 can drive selected word line 106 such that selected memory cell 103 can be written into or read out, on a particular pair of bitlines 118, according to the bit address supplied to memory address inputs 114.

Bitline controller 116 can include precharge cells 120, column multiplexers 122, sense amplifiers 124, and input/output buffers 126. Because differential read/write schemes are typically used for memory cells, it is desirable that bitlines be placed in a well-defined state before being accessed. Precharge cells 120 can be used to set up the state of bitlines 118, through I a PRECHARGE cycle, according to a predefined precharging scheme. In a static precharging scheme, precharge cells 120 can be left continuously on. While often simple to implement, static precharging can add a substantial power burden to active device operation. Dynamic precharging schemes can use clocked precharge cells 120 to charge the bitlines and, thus, can reduce the power budget of structure 100. In addition to establishing a defined state on bitlines 118, precharging cells 120 can also be used to effect equalization of differential voltages on bitlines 118 prior to a read operation. Sense amplifiers 124 allow the size of memory cell 103 to be reduced by sensing the differential voltage on bitline 118, which is indicative of its state, and translating that differential voltage into a logic-lever signal.

In general a READ operation is performed by enabling row decoder I 10, which selects a particular row. The charge on one bitlines 118 from each pair of bitlines on each column will discharge through the enabled memory cell 103, representing the state of the active cells 103 on that column 105. Column decoder 122 will enable only one of the columns, and will connect bitlines 118 to input/output buffer 126. Sense amplifiers 124 provide the driving capability to source current to input/output buffer 126. When sense amplifier 124 is enabled, the unbalanced bitlines 118 will cause the balanced sense amplifier to trip toward the state of the bitlines, and data 125 will be output by buffer 126.

A WRITE operation is performed by applying data 125 to 1/0 buffers 126. Prior to the WRITE operation, bitlines 118 are precharged by precharge cells 120 to a predetermined value.

The application of input data 125 to 1/0 buffers 126 tend to discharge the precharge voltage on one of the bitlines 118, leaving one bitline logic HIGH and one bitline logic LOW. Column decoder 122 selects a particular column 105 connecting bitlines 118 to 1/0 buffers 126, thereby discharging one of the bitlines 118. The row decoder I 10 selects a particular row, and the information on bitlines 118 will be written on cell 103 at the intersection of column 105 and row 106. At the beginning of a typical internal timing cycle, precharging is disabled, and is not enabled again until the entire operation is completed. Column decoder 122 and row decoder I 10 are then activated, followed by the activation of sense amplifier 124. At the conclusion of a

READ or a WRITE operation, sense amplifier 124 is deactivated. This is followed by disabling decoders 110, 122, at which time precharge cells 120 become active again during a subsequent PRECHARGE cycle. In general, keeping sense amplifier 124 activated during the entire READ/WRITE operation leads to excessive device power consumption, because sense amplifier 124 needs to be active only for the actual time required to sense the state of memory cell 103.

Figure 2 illustrates one implementation of memory cell 103 in Figure 1, in the form of six-transistor CMOS cell 200. Transistor cell 200 is one type of transistor which also may be used in embodiments of the present invention. SRAM cell 200 can be in one of three possible states:
(1) the STABLE state, in which cell 200 holds a signal value corresponding to a logic "I" or logic "0"; (2) a READ operation state; or (3) a WRITE operation state. In the STABLE state, memory cell 200 is effectively disconnected from the memory core (e.g., core 102 in FIG. 1).

I Bitlines 202, 204 are precharged HIGH (logic "I") before any operation (READ or WRITE) can take place. Row select transistors 206, 208 are turned off during precharge. Precharge power is supplied by precharge cells (not shown) coupled with the bitlines 202, 204, similar to precharge cells 120 in Figure 1. A READ operation is initiated by performing a PRECHARGE cycle, precharging bitlines 202, 204 to logic HIGH, and activating word line 205 using row select transistors 206, 208. One of the bitlines 202, 204 discharges through bit cell 200, and a differential voltage is setup between the bitlines 202, 204. This voltage is sensed and amplified to logic levels. A WRITE operation to cell 200 is carried out after another PRECHARGE cycle, by driving bitlines 202, 204 to the required state, and activating word line 205. CMOS is a desirable technology because the supply current drawn by such an SRAM cell typically is limited to the leakage current of transistors 201a-d while in the STABLE state.

As memory cell density increases, and as memory components are further integrated into more complex systems, it becomes imperative to provide memory architectures that are robust, reliable, fast, and area- and power-efficient. Single-core architectures, similar to those illustrated in FIG. 1, are increasingly unable to satisfy the power, speed, area and robustness constraints for a given high-performance memory application. Therefore, it is desirable to minimize power consumption, increase device speed, and improve device reliability and robustness, and numerous approaches have been developed to those ends. The advantages of the present invention may be better appreciated within the following context of some of these approaches, particularly as they relate to power reduction and speed improvement, and to redundancy and robustness.

POWER REDUCTION AND SPEED IMPROVEMENT In reference to FIG. 1, the content of memory cell 103 of memory block 100 is detected in sense amplifier 102, using a differential signal between bitlines 104, 106. However, this architecture is not scalable. Also, as memory block 100 is made larger, there are practical limitations to the ability of sense amplifier 102 to receive an adequate signal in a timely fashion at bitlines 104, 106. Increasing the length of bitlines 104, 106, increases the associated bitline capacitance and, thus, increases the time needed for a signal to develop on bitlines 104, 106.

More power must be supplied to lines 104, 106 to overcome the additional capacitance. Also, under the architectures of the existing art, it takes more time to precharge longer bitlines, thereby reducing the effective device speed. Similarly, writing to longer bitlines 104, 106, as found in the existing art, requires more extensive precharging, thereby increasing the power demands of the circuit, and further reducing the effective device speed.

In general, reduced power consumption in memory devices such as structure 100 in FIG. 1 can be accomplished by, for example, reducing total switched capacitance, and minimizing voltage swings. The advantages of the power reduction aspects of certain embodiments of the present invention can further be appreciated within the context of switched capacitance reduction I and voltage swing limitation.

SWITCHED CAPACITANCE REDUCTION As the bit density of memory structures increases, it has been observed that single-core memory structures can have unacceptably large switching capacitances associated with each memory access. Access to any bit location within such a single-core memory necessitates enabling the entire row, or word line, in which the datum is stored, and switching all bitlines in the structure. Therefore, it is desirable to design high-performance memory structures to reduce the total switched capacitance during any given access.

Two well-known approaches for reducing total switched capacitance during a memory structure access include dividing a single-core memory structure into a banked memory structure, and employing divided word line structures. In the former approach, it is necessary to activate only the particular memory bank associated with the memory cell of interest. In the latter approach, total switched capacitance is reduced by localizing word line activation to the greatest practicable extent.

Divided or Banked Memory Core One approach to reducing switching capacitances is to divide the memory core into separately switchable banks of memory cells. Typically, the total switched capacitance during a given memory access for banked memory cores is inversely proportional to the number of banks employed. Byjudiciously selecting the number and placement of bank units within a given memory core design, as well as the type of decoding used, the total switching capacitance, and thus the overall power consumed by the memory core, can be greatly reduced. A banked design also may realize a higher product yield, because the memory banks can be arranged such that a defective bank is rendered inoperable and inaccessible, while the remaining operational banks of the memory core can be packed into a lower-capacity product.

However, banked designs may not be appropriate for certain applications. Divided memory cores demand additional decoding circuitry to permit selective access to individual banks, and incur a delay as a result. Also, many banked designs employ memory segments that are merely scaled-down versions of traditional monolithic core memory designs, with each segment having dedicated control, precharging, decoding, sensing, and driving circuitry. These circuits tend to consume much more power in both standby and operational modes, than do their associated memory cells. Such banked structures may be simple to design, but the additional complexity and power consumption thus can reduce overall memory component performance.

By their very nature, banked designs are not suitable for scaling-up to accommodate large design requirements. Also, traditional banked designs may not be readily conformable to applications requiring a memory core configuration that is substantially different from the underlying memory bank architecture (e.g., a memory structure needing relatively few rows of I very long bit-length word lengths). Rather than resort to a top-down division of the basic memory structure using banked memory designs, preferred embodiments ofthe present invention provide a hierarchical memory structure that is synthesized using a bottom-up approach, by hierarchically coupling basic memory modules with localized decision- making features that synergistically cooperate to dramatically reduce the overall power needs, and improve the operating speed, of the structure. At a minimum, such a basic hierarchical module can include localized bitline sensing.

Divided Word Line Often, the bit-width of a memory component is sized to accommodate a particular word length. As the word length for a particular design increases, so do the associated word line delays, switched capacitance, power consumption, and the like. To accommodate very long word lines, it may be desirable to divide core-spanning global word lines into local word lines, each consisting of smaller groups of adjacent, word-oriented memory cells. Each local group employs local decoding and driving components to produce the local word line signals when the global word line, to which it is coupled, is activated. In long word length applications, the additional overhead incurred by divided word lines can be offset by reduced word line delays, power consumption and so forth. However, the added overhead imposed by existing divided word line schemes may make it unsuitable for many implementations. As before, rather than resorting to the traditional top-down division of word lines, certain preferred embodiment of the invention herein include providing a local word line to the aforementioned basic memory module, which further enhances the local decision making features of the module. As before, by using a bottom up approach to hierarchically couple basic memory modules, here with the added localized decision-making features of local word lines according to the present invention, additional synergies are realized, which further reduce overall power consumption and signal propagation times.

VOLTAGE-SWING REDUCTION TECHNIQUE Power reduction also can be achieved by reducing the voltage swings experienced throughout the structure. By limiting voltage swings, it is possible to reduce the amount ofpower dissipated as the voltage at a node or on a line decays during a particular event or operation, as well as to reduce the amount of power required to return the various decayed voltages to the desired state after the particular event or operation, or prior to the next access. Two techniques to this end include using pulsed word lines and sense amplifier voltage swing reduction.

Pulsed Word Lines By enabling a word line just long enough to correctly detect the differential voltage across a selected memory cell, it is possible to reduce the bitline voltage discharge corresponding to a I READ operation on the selected cell. In some designs, by applying a pulsed signal to the associated word line over a chosen interval, a sense amplifier is activated only during that interval, thereby reducing the duration of the bitline voltage decay. These designs typicaHy use some form of pulse generator that produces a fixed-duration pulse. If the duration of the pulse is targeted to satisfy worst-case timing scenarios, the additional margin will result in unnecessary bitline current draw during nominal operations. Therefore, it is desirable to employ a self-timed, self-limiting word line device that is responsive to the actual duration of a given READ operation on a selected cell, and that substantially limits word line activation to that duration. Furthermore, where a sense amplifier can successfully complete a READ operation in less than a memory system clock cycle, it also may be desirable that the pulse width activation be asynchronous, relative to the memory system clock. Certain aspects of the present invention provide a pulsed word line signal, for example, using a cooperative interaction between global and local word line decoders.

Sense A=Iifier Voltage Swing Reduction In order to make large memory arrays, it is most desirable to keep the size of an individual memory cell to a minimum. As a result, individual memory cells generally are incapable of supplying driving current to associated input/output bitlines. Sense amplifiers typically are used to detect the value of the datum stored in a particular memory cell and to provide the current needed to drive the 1/0 lines. In sense amplifier design, there typically is a trade-off between power and speed, with faster response times usually dictating greater power requirements. Faster sense amplifiers can also tend to be physically larger, relative to low speed, low power devices.

Furthermore, the analog nature of sense amplifiers can result in their consuming an appreciable fraction of the total power. Although one way to improve the responsiveness of a sense amplifier is to use a more sensitive sense amplifier, any gained benefits are offset by the concomitant circuit complexity which nevertheless suffers from increased noise sensitivity. It is desirable, then, to limit bitline voltage swings and to reduce the power consumed by the sense amplifier.

In one typical design, the sense amplifier detects the small differential signals across a memory cell, which are in an unbalanced state representative of datum value stored in the cell, and amplifies the resulting signal to logic level. Prior to a READ operation, the bitlines associated with a particular memory column are precharged to a chosen value. When a specific memory cell is enabled, a row decoder selects the particular row in which the memory cell is located, and an associated column decoder selects a sense amplifier associated with the particular column. The charge on one of those bitlines is discharged through the enabled memory cell, in a manner corresponding to the value of the datum stored in the memory cell. This produces an imbalance between the signals on the paired bitlines, and causing a bitline voltage swing. When enabled, the sense amplifier detects the unbalanced signal and, in response, the usually-balanced sense amplifier state changes to a state representative of the value of the datum. This state I detection and response occurs within a finite period, during which a specific amount of power is dissipated. The longer it takes to detect the unbalanced signal, the greater the voltage decay on the precharged bitlines, and the more power dissipated during the READ operation. Any power that is dissipated beyond the actual time necessary for sensing the memory cell state, is truly wasted power. In traditional SRAM designs, the sense amplifiers that operate during a particular READ operation, remain active during nearly the entire read cycle. However, this approach unnecessarily dissipates substantial amounts of power, considering that a sense amplifier needs to be active just long enough to correctly detect the differential voltage across a selected memory cell, indicating the stored memory state.

There are two general approaches to reducing power in sense amplifiers. First, sense amplifier current can be limited by using sense amplifiers that automatically shut off once the sense operation has completed. One sense amplifier design to this end is a self-latching sense amplifier, which turns off as soon as the sense amplifier indicates the sensed datum state.

Second, sense amplifier currents can be limited by constraining the activation of the sense amplifier to precisely the period required. This approach can be realized through the use of a dummy column circuit, complete with bit cells, sense amplifier, and support circuitry. By mimicking the operation of a functional colurrin, the dummy circuit can provide to a sense amplifier timing circuit an approximation of the activation period characteristic of the functional sense amplifiers in the memory system. Although the dummy circuit approximation can be quite satisfactory, there is an underlying assumption that all functional sense amplifiers have completed the sensing operation by the time the dummy circuit completes the its operation. In that regard, use of a dummy circuit can be similar to enabling the sense amplifiers with a fixed-duration pulsed signal. Aspects of the present invention provide circuitry and sense amplifiers which limit voltage swings, and which improve the sensitivity and robustness of sense amplifier operation.

For example, compact, power-conserving sense amplifiers having increased immunity to noise, as well as to intrinsic and operational offsets, are provided. In the context of the present invention, such sense amplifiers can be realized at the local module tier, as well as throughout the higher tiers of a hierarchical memory structure, according to the present invention.

REDUNDANCY Memory designers typically balance power and device area against speed. High- performance memory components place a severe strain on the power and area budgets of associated systems particularly where such components are embedded within a VLSI system, such as a digital signal processing system. Therefore, it is highly desirable to provide memory subsystems that are fast, yet power-and area-efficient. Highly integrated, high performance components require complex fabrication and manufacturing processes. These processes experience unavoidable parameter variations which can impose physical defects upon the units being produced, or can exploit design vulnerabilities to the extent of rendering the affected units I unusable, or substandard.

In a memory structure, redundancy can be important, for example, because a fabrication flaw, or operational failure, of even a single bit cell may result in the failure of the system relying uponthememory. Likewise, process invariant features maybe needed to insure that the internal operations of the structure conform to precise timing and parametric specifications. Lacking redundancy and process invariant features, the actual manufacturing yield for a particular memory structure can be unacceptably low. Low-yield memory structures are particularly unacceptable when embedded within more complex systems, which inherently have more fabrication and manufacturing vulnerabilities. A higher manufacturing yield translates into a lower per-unit cost and robust design translates into reliable products having lower operational costs. Thus, it is also highly desirable to design components having redundancy and process invariant features wherever possible.

Redundancy devices and techniques constitute other certain preferred aspects of the invention herein which, alone or together, enhance the functionality of the hierarchical memory structure. The aforementioned redundancy aspects of the present invention can render the hierarchical memory structure less susceptible to incapacitation by defects during fabrication or during operation, advantageously providing a memory product that is at once more manufacturable and cost-efficient, and operationally more robust. Redundancy within a hierarchical memory module can be realized by adding one or more redundant rows, colurrms, or both, to the basic module structure. In one aspect of the present invention a decoder enabling row redundancy is provided. Moreover, a memory structure composed of hierarchical memory modules can employ one or more redundant modules for mapping to failed memory circuits. A redundant module can provide a one-for-one replacement of a failed module, or it can provide one or more memory cell circuits to one or more primary memory modules.

MEMORY MODULE WITH HIERARCHICAL FUNCTIONALITY The modular, hierarchical memory architecture according to the invention herein provides compact, robust, power-efficient, high-performance memory system having, advantageously, flexible and extensively scalable architecture. The hierarchical memory structure is composed of fundamental memory modules which can be cooperatively coupled, and arranged in multiple hierarchical tiers, to devise a composite memory product having arbitrary column depth or row length. This bottom-up modular approach localizes timing considerations, decision making, and power consumption to the particular unit(s) in which the desired data is stored.

Within a defined design hierarchy, the fundamental memory modules can be grouped to form a larger memory block, that itself can be coupled with similar memory structures to form still larger memory blocks. In turn, these larger structures can be arranged to create a complex structure at the highest tier of the hierarchy. In hierarchical sensing, it is desired to provide two or more tiers of bit sensing, thereby decreasing the read and write time of the device, i.e., I increasing effective device speed, while reducing overall device power requirements. In a hierarchical design, switching and memory cell power consumption during a read/write operation are localized to the immediate vicinity of the memory cells being evaluated or written, i.e., those memory cells in selected memory modules, with the exception of a limited number of global word line selectors and sense amplifiers, and support circuitry. The majority of modules that do not contain the memory cells being evaluated or written generally remain inactive.

Preferred embodiments of the present invention provide a hierarchical memory module using local bitline sensing, local word line decoding, or both, which intrinsically reduces overall power consumption and signal propagation, and increases overall speed, as well as design flexibility and scalability. Aspects of the present invention contemplate apparatus and methods which further limit the overall power dissipation of the hierarchical memory structure, while minimizing the impact of a multi-tier hierarchy. Certain aspects of the present invention are directed to mitigate functional vulnerabilities that may develop from variations in operational parameters, or that related to the fabrication process. In addition, devices and techniques are disclosed which advantageously ameliorate system performance degradation resulting from temporal inefficiencies, including, without limitation, a high-precision delay measurement circuit, a diffusion delay replication circuit and associated dummy devices. In another aspect of the present invention, an asynchronously resettable decoder is provided that reduces the bitline voltage discharge, corresponding, for example, to a READ operation on the selected cell, by limiting word-line activation to the actual time required for the sense amplifier to correctly detect the differential voltage across a selected memory cell.

HIERARCHICAL MEMORY MODULES In prior art memory designs, such as the aforementioned banked designs, large logical memory blocks are divided into smaller, physical modules, each having the attendant overhead of an entire block of memory including predecoders, sense amplifiers, multiplexers, and the like.

In the aggregate, such memory blocks would behave as an individual memory block. However, using the present invention, memory blocks of comparable, or much larger, size can be provided by coupling hierarchical functional modules into larger physical memory blocks of arbitrary number of words and word length. For example, existing designs which aggregate smaller memory blocks into a single logical block usually require the replication of the predecoders, sense amplifiers, and other overhead circuitry that would be associated with a single memory block. According to the present invention, this replication is unnecessary, and undesirable. One embodiment of the invention comprehends local bitline sensing, in which a limited number of memory cells are coupled with a single local sense amplifier, thereby forming a basic memory module. Similar memory modules are grouped and arranged to output the local sense amplifier signal to the global sense amplifier signal.

Thus, the bitlines associated with the memory cells are not directly coupled with a global sense amplifier, mitigating the signal propagation delay and I power consumption typically associated with global bitline sensing. In this approach, the local bitline sense amplifier quickly and economically sense the state of a selected memory cell and report the state to the global sense amplifier. In another embodiment of the invention herein, the delays and power consumption of global word line decoding are mitigated by providing a memory module, composed of a limited number of memory cells, having local word line decoding. Similar to the local bitline sensing approach, a single global word line decoder can be coupled with the respective local word line decoders of multiple modules. When the global decoder is activated with an address, only the local word line decoder associated with the desired memory cell responds, and activates the memory cell. This aspect, too, is particularly power conservative and fast, because the loading on the global line is limited to the associated local word line decoders, and the global word line signal need be present only as long as required to trigger the relevant local word line. In yet another embodiment of the present invention, a hierarchical memory module employing both local bitline sensing and local word line decoding is provided, which realizes the advantages of both approaches. Each of the above embodiments are discussed forthwith.

Local Bitline Seaging FIG. 3 illustrates a memory block 300 formed by coupling multiple cooperating constituent modules 320a-e, with each of the modules 320a-e having a respective local sense amplifier 308a-e. Each module is composed of a predefined number of memory cells 325a-g, which are coupled with one of the respective local sense amplifiers 308a- e. Each local sense amplifiers 308a-e is coupled with global sense amplifier 302 via bitlines 304,306. Becauseeach of local sense amplifiers 3 08a-e sense only the local bitlines 3 1 Oa-e, 12a-e, of the respective memory modules 320a-e, the amount of time and power necessary to precharge local bitlines 310a-e and 312a-e are substantially reduced. Only when local sense amplifier 308a-e senses a signal on respective local lines 310a-e and 312a-e, does it provide a signal to global sense amplifier 302. This architecture adds flexibility and scalability to a memory architecture design because the memory size can be increased by adding locally-sensed memory modules such as 320a-e.

Increasing the numberof local sense amplifiers 308a-e attached to global bitlines 304,306, does not significantly increase the loading upon the global bitlines, or increase the power consumption in global bitlines 3 04, 3 06 because signal development and precharging occur only in the local sense amplifier 308a-e, proximate to the signal found in the memory cells 325a-g within corresponding memory module 320a-e.

In preferred embodiments of the invention herein, it is desirable to have each module be self-timed. That is, each memory module 320a-e can have internal circuitry that senses and establishes a sufficient period for local sensing to occur. Such self- timing circuitry is well-known in the art. In single-core designs, or even banked designs, self-timing memory cores may be I unsuitable for high-performance operation, because the timing tends to be dependent upon the slowest of many components in the structure, and because the signal propagation times in such large structures can be significant. The implementation of self-timing in these larger structures can be adversely affected by variations in fabrication and manufacturing processes, which can substantially impact the operational parameters of the memory array and the underlying timing circuit components.

In a hierarchical memory module, self-timing is desirable because the timing paths for each module 320a-e comprehends only a limited number of memory cells 325a- g over a very limited signal path. Each module, in effect, has substantial autonomy in deciding the amount of time required to execute a given PRECHARGE, READ, or WRITE operation. For the most part, the duration of an operation is very brief at the local tier, relative to the access time of the overall structure, so that memory structure 3 00 composed of hierarchical memory modules 3 20a-e is not subject to the usual difficulties associated with self-timing, and also is resistant to fabrication and manufacturing process variations.

In general, the cores of localized sense amplifiers 308a-e can be smaller than a typical global sense amplifier 302, because a relatively larger signal develops within a given period on the local sense amplifier bitlines, 3 1 Oa-e, 312a-e. That is, there is more signal available to drive local sense amplifier 308a-e. Ina global-sense-amplifier-only architecture, a greater delay occurs while a signal is developed across the global bitlines, which delay can be decreased at the expense of increased power consumption. Advantageously, local bit sensing implementations can reduce the delay while simultaneously reducing consumed power.

In certain aspects ofthe invention herein, detailed below, a limited swing driver signal can be sent from the active local sense amplifier to the global sense amplifier. A full swing signal also may be sent, in which case, a very simple digital buffer, may be used. However, if a limited swing signal is used, a more complicated sense amplifier may be needed. For a power constrained application, it may be desirable to share local sense amplifiers among two or more memory modules. Sense amplifier sharing, however, may slightly retard the bit signal development line indirectly because, during the first part of a sensing period, the capacitances of each of the top and the bottom shared memory modules are being discharged. However, this speed decrease can be minimized and is relatively small, when compared to the benefits gained by employing logical sense amplifiers over the existing global-only architectures. Moreover, preferred embodiments of the invention herein can obviate these potentially adverse effects of sense amplifier sharing by substantially isolating the local sense amplifier from associated local bitlines which are not coupled with the memory cell to be sensed.

FIG. 4 shows a memory structure 400, which is similar to structure 300 in FIG. 3, by providing local bitline sensing of modules 420a-d. Each memory module 420a-d is composed of a predefined number of memory cells 425a-g. Memory cells 425a-g are coupled with respective local sense amplifier 408a, b via local bitlines 410a-d, 412a-d. Unlike structure 300 in FIG. 3, I where each module 320a-e has its own local sense amplifier 308a-e, memory modules 420a-d are paired with a single sense amplifier 408a, b. Similar to FIG. 3, FIG. 4 shows global sense amplifier 402 being coupled with local sense amplifiers 408a, 408b.

FIG. 5 further illustrates that memory structures such as module 300 in FIG. 3 can be coupled such that the overall structure is extended in address size (this is vertically), or in bit length (this is horizontally), or both. The arrayed structure in FIG. 5 also can use modules such as module 400 in FIG. 4. FIG. 5 also illustrates that a composite memory structure 500 using hierarchical memory modules can be truly hierarchical. Memory blocks 502, 503 can be composed of multiple memory modules, such as module 504, which can be modules as described in reference to FIG. 3 and FIG. 4. Each memory block 502, 503 employs two- tier sensing, as previously illustrated. However, in structure 500, memory blocks 502, 503 employ an intermediate tier of bitline sensing, using, for example, midtier sense amplifiers 514, 516. Under the hierarchical memory paradigm, midtier sense amplifiers 514, 516 can be coupled with global sense amplifier 520. Indeed, the hierarchical memory paradigm, in accordance with the present invention, can comprehend a highly-scalable multi-tiered hierarchy, enabling the memory designer to devise memory structures having memory cell densities and configurations that are tailored to the application. Advantageously, this scalability and configurability can be obtained without the attendant delays, and substantially increased power and area consumption of prior art memory architectures.

One of the key factors in designing a faster, power-efficient device is that the capacitance per unit length of the global bitline can be made less than the capacitance of the local bitlines.

This is because, using the hierarchical scheme, the capacitance of the global bitline is no longer constrained by the cell design. For example, metal lines can be run on top of the memory device.

Also, a multiplexing scheme can be used that increase the pitch of the bitlines, thereby dispersing them, further reducing bitline capacitance. Overall, the distance between the global bitlines can be wider, because the memory cells are not directly connected to the global bitlines. Instead, each cell, e.g. cell 303 in Fig 3., is connected only to the local sense amplifier, e.g. sense amplifier 308a-e.

Local Word Line Decoding FIG. 6 illustrates a hierarchical structure 600 having hierarchical word- line decoding in which each hierarchical memory module 605 is composed of a predefined number of memory cells 6 10, which are coupled with a particular local word line decoder 615 a-c. Each local word line decoder 615a-c is coupled with a respective global word line decoder 620. Each global word line decoder 620a-d is activated when predecoder 622 transmits address information relevant to a particular global word line decoder 620a-d via predecoder lines 623. In response, global word line decoder 620a-d activates global word line 630 which, in turn, activates a particular local word line decoder 615a-c. Local word line decoder 615a-c then enables associated memory I module 605, so that the particular memory cell 610 of interest can be evaluated. Each of memory modules 605 can be considered to be an independent memory component to the extent that the hierarchical functionality of each of modules 605 relies upon local sensing via local sense amplifiers 608a-b, local decoding via local word line decoders 615a-c, or both. As with other preferred embodiments of the invention herein, it is desirable to have each module 605 be self timed. Self-timing can be especially useful when used in conjunction with local word line decoding because a local timing signal ftom a respective one of memory module 605 can be used to terminate global word line activation, local bitline sensing, or both.

Similar to the scaling illustrated in FIG. 5, multiple memory devices 600 can be arrayed coupled with global bitlines or global decoding word lines, to create a composite memory component of a desired size and configuration. In an embodiment of the present invention, 256 rows of memory are used in each module 605, allowing the memory designer to create a memory block of arbitrary size, having a 256 row granularity. For prior art memory devices, a typical realistic limitation to the number of bits sense per sense amplifier is about 512 bit. Long bit or word lines can present a problem, particularly for a WRITE operations, because the associated driver can be limited by the amount of power it can produce, and the speed at which sufficient charge can be built-up upon signal lines, such as global bitlines 604, 606 in FIG. 6.

Although FIG. 6 shows hierarchical word line decoding used in conjunction with hierarchical bitline operations, hierarchical word-line decoding can be implemented without hierarchical bitline sensing. It is preferred to use both the hierarchical word line decoding, and the hierarchical bitline sensing to obtain the synergistic effects of decreased power and increased speed for the entire device.

Hierarchical Functionalily In typical designs, power intends to increase approximately linearly with the size of the memory. However, according to the present invention, as illustrated in FIG. 3 through FIG. 6, power requirements may increase only fractionally as the overall memory structure size increases, primarily because only the memory module, and associated local bitlines and local word lines are activated during a given operation. Due to the localized functionality, the global bitlines and word lines are activated for relatively brief periods at the beginning and end of the operation. In any event, power consumption is generally dictated by the bit size of the word, and the basic module configuration, i.e., the number of rows and row length of modules 620a-e. Thus, significant benefits can be realized by judiciously selecting the configuration of a memory module, relative to the overall memory structure configuration. For example, in a memory structure according to the present invention, a doubling in the size of the memory device can account for power consumption increase of about twenty percent, and not a doubling, as found in prior art designs. Furthermore, a memory structure according to the present invention can realize a four-to-six-fold decrease in power requirements and can operate 0% to 50% faster, and I often more, than traditional architectures.

FIG. 7 illustrates that memory structures according to the present invention, for example memory structure 740, are fully hierarchical, in that each tier within the hierarchy includes local bit line sensing, local word line decoding, or both. Exemplary memory structure 740 is three-tier hierarchical device with memory module 700 being representative of the fundamental, or lowest, tier (LO) of the memory hierarchy; memory device 720 being representative of the intermediate tier(L) ofthe memory hierarchy; and memory structure 740 being representative ofthe upper tier (L2)of the memory hierarchy. For the sake of simplicity, only one memory column is shown at each tier, such that memory column 702 is intended to be representative of fundamental tier (LO) memory column 722 of intermediate tier(L I), and memory column 742 of upper tier (L2)' Tier Lo memory devices, such as memory module 700, are composed of multiple memory cells, generally indicated by memory cell 701, which can be disposed in row, column, or 2-D array (row and column) formats. Memory module 700 is preferred to employ local bit line sensing, local word line decoding, or both, as was described relative to FIGS. 3 through 6. In the present example, module MOO includes both local bit line sensing and local word line decoding.

Each memory cell MO 1 in a respective column of memory cells 702 is coupled with local sense amplifier 703 by local bit lines 704a, 704b. Although local bit line sensing can be performed on a memory column having a single memory cell, it is preferred that two, or more, memory cells 701 be coupled with local sense amplifier 703. Unlike some prior art memory devices which dispense with local bit line sensing by employing special memory cells which provide strong signals at full logic levels, module 700 can use, and indeed is preferred to use, conventional and low-power memory cells 701 as constituent memory cells. An advantage of local bit line sensing is that only a limited voltage swing on bit lines 704a, 704b may be needed by local sense amplifier 703 to accurately sense the state of memory cell 70 1, which permits rapid memory state detection and reporting using substantially less power than with prior art designs. Tier Lo local sense amplifier 703 detects the memory state of memory cell 701 by coupling the memory state signal to tier Lo local sense amplifier 703, via local bit lines 704a, 704b. It is preferred that the memory state signal be a limited swing voltage signal. Amplifier 703 transmits a sensed signal representative of the memory state of memory cell 701 to tier L, sense amplifier 723 via tier Lo local sense amplifier outputs 705 a, 705b, which are coupled with intermediate tier bit lines 724a, 724b. It is preferred that the sensed signal be a limited swing voltage signal, as well. In turn, amplifier 723 transmits a second sensed signal representative of the memory state of memory cell 701 to tier L2sense amplifier 743, via tier L, local sense amplifier outputs 725a, 725b, which are coupled with upper tier bit lines 744a, 744b. It also is preferred that the second sensed signal be a limited voltage swing signal.

Where tier L2is the uppermost tier of the memory hierarchy, as is illustrated in the instant example, sense amplifier 743 can be a global sense amplifier, which propagates a third signal representative of memory cell 701 to associated 1/0 circuitry (not shown) via sense amplifier I output lines 746a, 746b. Such 1/0 circuitry can be similar to 1/0 in FIG. 1. However, the present invention contemplates a hierarchical structure that can consist of two, three, four, or more, tiers of hierarchy. The uppermost tier signal can be a fall-swing signal. In view of FIG. 7, a skilled artisan would realize that "local bit line sensing" occurs at each tier Lo, L1, and L2, in the exemplary hierarchy, and is desirable, for example, because only a limited voltage swing may be needed to report the requested memory state from a lower tier in the hierarchy to the next higher tier.

Hierarchical memory structures also can employ local word line decoding, as illustrated in memory device 740. In FIG. 7, memory device 740 is the uppermost tier (L2) in the hierarchical memory structure, thus incoming global word line signal 746 is received from global word line drivers (not shown) such as global row address decoders I 10 in FIG. 1. In certain preferred embodiments of the present invention, predecoding is employed to effect rapid access to desired word lines, although predecoding is not required, and may not be desired, at every tier in a particular implementation. Signal M46 is received by upper tier predecoder 747, predecoded and supplied to upper tier (L2) global word line decoders, such as global word line decoder 748.

Decoder M48 is coupled with local word line decoder 749 by way of upper tier global word line 750, and selectively activates upper tier local word line decoder 749. Activated L2 local decoder M49, in turn, activates L2 local word line 75 1, which propagates selected word line signal 726 to intermediate tier (L,) predecoder 727. Predecoder 727 decodes and activates the appropriate intermediate tier (L,) global word line decoder, such as global word line decoder 728. Decoder 728 is coupled with, and selectively activates, tier L, local word line decoder 729 by way of tier (L,) global word line 730. Activated L, local decoder 729, in turn, propagates a selected word line signal 706 to fundamental tier (LO) predecoder 707, which decodes and activates the appropriate tier Lo global word line decoder, such as global word line decoder 708. Activated Lo local decoder 709, in turn, activates Lo local word line 711, and selects memory cell 701 for access. In view of the foregoing discussion of hierarchical word line decoding, a skilled artisan would realize that "local word line decoding" occurs at each tier Lo, L I, and L2 in the exemplary hierarchy, and is desirable because a substantial reduction in the time and power needed to access selected memory cells can be realized.

Although local word line decoding within module 700 is shown in the context of a single column of memory cells, such as memory columns 702, 722, 742, the present invention contemplates that local word line decoding be performed across two, or more, columns in each of hierarchy tiers, with each of the rows in the respective columns employing two or more local word line decoders, such as local word line decoders 709, 729, 749 which are coupled with respective global word line decoders, such as global word line decoders 708, 728, 748 by way of respective global word lines, such as global word lines 710, 730, 750. However, there is no requirement that equal numbers of rows and columns be employed at any two tiers of the hierarchical structure. In general, memory device 720 can be composed of multiple memory I modules 700, which fundamental modules 700 can be disposed in row, column, or 2-D array (row and column) array formats. Such fundamental memory modules can be similar to those illustrated with respect to FIG. 3 through FIG. 6, and combinations thereof Likewise, memory device 740 can be composed of multiple memory devices 720, which intermediate devices 720 also can be disposed in row, column, or 2-D array (row and column) formats. This extended, and extendable, hierarchality permits the formation of multidimensional memory modules that are distinct from prior art hierarchy-like implementations, which generally are 2-D groupings of banked, paged, or segmented memory devices, or register file memory devices, lacking local functionality at each tier in the hierarchy.

Fast Decoder with Asynchronous Reset Typically, local decoder reset can be used to generate narrow pulse widths on word lines in a fast memory device. The input signals to the word line decoder are generally synchronized to a clock, or chip select, signal. However, it is desirable that the word line be reset independently of the clock and also of the varying of the input signals to the word line decoder.

FIG. 8 is a circuit diagram illustrative of an asynchronously-resettable decoder 800 according to this aspect of the present invention. It may be desirable to implement the AND function, for example, by source-coupled logic. The capacitance on the input x2 - n 802 can be generally large, therefore the AND function is performed with about one inverter delay plus three buffer stages. The buffers are skewed, which decreases the load capacitance by about one-half and decreases the buffer delay.

In order to be able to independently reset word line WL 804, it is desirable that inputs 802, 803 be isolated from output 804, and the node 805 should be charged to Vdd, turning off the large PMOS driver M8 807 once word line WL 804 is set to logical HIGH. Charging of node 805 to Vdd can be accomplished by a feedback-resetting loop. Inputs 802, 803 can be isolated from output 804 setting NMOS device 808 to logic LOW. When output WL 804 goes high, monitor node 8 10 is discharged to ground, and device MO 812 is shut-off, thus isolating inputs 802, 803 from output WL 804. The feedback loop precharges the rest of the nodes in the buffers via monitor node 8 10, and PMOSFET M1 3 815 is turned on, connecting the input x2 - n 802 to node 810. Decoder 800 will not fire again until x2-n 802 is reset to Vdd, which usually happens when the system clock signal changes to logic LOW. Once x2 - n 802 is logic HIGH, node 8 10 charges to Vdd, with the assistance of PMOS device M14 818, and device MO 812 is turned on. Thisturns off PMOS device M13 815, thus isolating input x2 - n 802 from the reset loop which employs node 810. Decoder 800 is now ready for the next input cycle.

Limited Swiniz Driver Circuit FIG. 9 illustrates limited swing driver circuit 900 according to an aspect of the invention herein. In long word length memories, a considerable amount of power may be consumed in the I data buses. Limiting the voltage swing in such buses can decrease the overall power dissipation of the system. This also can be true for a system where a significant amount of power is dissipated in switching lines with high capacitance. Limited-swing driver circuit 900 can reduce power dissipation, for example, in high capacitance lines. When IN signal 902 is logic HIGH, NMOS transistor MN 1904 conducts, and node 905 is effectively pulled to ground. In addition, bitline 9 10 is discharged through PMOSFET MP 1912. By appropriate device sizing, the voltage swing on bitline 910 can be limited to a desired value, when the inverter, formed by CMOSFETS MP2 914 and MN2 916, switches OFF PMOSFET MP1 912. In general, the size of circuit 900 is related to the capacitance (Cbillia.) 918 being driven, and the sizes of MP2 914 and MN2 916.

In another embodiment of this aspect of the present invention, limited swing driver circuit includes a tri-state output enable, and a self-resetting feature. Tri- state functionality is desirable when data lines are multiplexed or shared. Although the voltage at memory cell node 905 can swing to approximately zero volts, it is most desirable that the bitline voltage swing only by about 200-300 mV.

Single-Ended Sense AMlifier with Sample-and-Hold Reference In general, single-ended sense amplifiers are useful to save metal space, however, existing designs tend not to be robust due to their susceptibility to power supply and ground noise. In yet another aspect of the present invention, FIG. 10 illustrates a single- ended sense amplifier 1000, preferably with a sample-and-hold reference. Amplifier 1000 can be useful, for example, as a global sense amplifier, sensing input data. At the beginning of an operation, Dataln 1004 is sampled, preferably just before the measurement begins. Therefore, supply, ground, or other noise will affect the reference voltage of sense amplifier 1000 generally in the same way noise affects node to be measured, tending to increase the noise immunity of the sense amplifier 1000.

Both inputs 10 10, 10 11 of differential amplifier 10 12 are at the voltage level of Dataln 1004 when the activate signal (GWSELH) 10 14 is logic LOW (i.e., at zero potential). At a preselected interval before the measurement begins, but before DataIn 10 13 begins to change, activate signal (GWSELH) 1014 is asserted to logic HIGH, thereby isolating the input node 1002 of the transistor M162 1008. The Dataln voltage existing just before the measurement is taken is sampled and held as a reference, thereby making the circuit substantially independent of ground or supply voltage references. Transistors M 190 1025 and M 187 1026 can add capacitance to the node 1021 where the reference voltage is stored. Transistor M190 1025 also can be used as a pump capacitance to compensate for the voltage decrease at the reference node 1021 when the activate signal becomes HIGH and pulls the source 1002 of M162 1008 to a lower voltage.

Feedback 1030 from output data Data - toLSA 1035, being transmitted to a local sense amplifier (not shown), is coupled with the source/drain of transistor M 187 1026, actively adjusting the reference voltage at node 1021 by capacitive coupling, thereby adjusting the amplifier gain adaptively.

I Sense Amplifier with Offset Cancellation and Charge-share Limited Swing Drivers In yet another aspect of the present invention, a latch-type sense amplifier I 100 with dynamic offset cancellation is provided. Sense amplifier 1100 also may be useful as a global sense amplifier, and is suited for use in conjunction with hierarchical bitline sensing. Typically, the sensitivity of differential sense amplifiers can be limited by the offsets caused by inherent process variations for devices ("device matching"), and dynamic offsets that may develop on the input lines during high-speed operation. Decreasing the amplifier offset usually results in a corresponding decrease in the minimum bitline swing required for reliable operation. Smaller bitline swings can lead to faster, lower power memory operation. With amplifier I 100, the offset on bitlines can be canceled by the triple PMOS precharge-and-balance transistors M3 I 10 1, M4 1102, M5 1103, which arrangement is known to those skilled in the art. However, despite precharge-and-balance transistors 1101-1103, an additional offset atthe inputs of the latchmay exist. By employing balancing PMOS transistor (M 14) 1110, any offset that may be present at the input of the latch-type differential sense amplifier can be substantially equalized. Sense amplifier I 100 demonstrates a charge-sharing limited swing driver 1115. Global bitlines 1150, 1151 are disconnected from sense amplifier 1100 when sense amplifier I 100 is not being used, i.e., in a tri-state condition. Sense amplifier I 100 can be in a precharged state if both input/output nodes are logic HIGH, i.e., if both of the PMOS drivers, M38 1130 and M29 1131 are off (inputs at logic 111GH). A large capacitor, Co 113 5, in sense amplifier 1100 can be kept substantially at zero volts by two series NMOS transistors, M3 7 1140 and M40 114 1. The size of capacitor 113 5 can be determined by the amount of voltage swing typically needed on global bitlines 1120, 112 1.

When sense amplifier 1100 is activated, and bitlines 1150, 1151 are logic HIGH, PMOS transistor M29 1131 is turned on and global bit - n 1150 is discharged with a limited swing.

When a bit to be read is logic LOW, PMOS transistor M38 1130 is turned on, and the global bit 1151 is discharged with a limited swing. This charge-sharing scheme can result in very little power consumption, because only the charge that causes the limited voltage swing on the global bitlines 1150, 1151 is discharged to ground. That is, there is substantially no "crowbar" current.

Furthermore, this aspect of the present invention can be useftil in memories where the global bitlines are multiplexed for input and output.

Module-tier Memory Redundancy Implementation In FIG. 12, memory structure 1200, composed ofhierarchical functional memory modules 1201 is preferred to have at least one or more redundant memory rows 1202, 1204; one, or more redundant memory columns 1206, 1208; or both, within each module 120 1. It is preferred that the redundant memory rows 1202, 1204, and/or columns 1206, 1208 be paired, because it has been observed that bit cell failures tend to occur in pairs. Module-level redundancy, as shown in FIG. 12, where redundancy is implemented using a preselected number of redundant memory rows 1202, 1204, or redundant memory columns 1206, 1208, within memory module 120 1, can I be a very area-efficient approach provided the typical number of bit cell failures per module remains small. By implementing only a single row 1202 or a single column 1206 or both in memory module 1201, only one additional multiplexer is needed for the respective row or column. Although it may be simpler to provide redundant memory cell circuits that can be activated during product testing during the manufacturing stage, it may also be desirable to activate selected redundant memory cells when the memory product is in service, e.g., during maintenance or on-the-fly during product operation. Such activation can be effected by numerous techniques and support circuitry which are well-known in the art.

Redundant Module Memory Redundangy IMplementation As shown in FIG. 13, memory redundancy also may be implemented by providing redundant module 1301 to memory structure 1300, which is composed ofprimary modules 1304, 1305,1306,1307. Redun-dantmodule 1301 can be a one-for-one replacement of a failed primary module, e.g, module 1304. In another aspect of the invention, redundant module 1301 may be partitioned into smaller redundant memory segments 13 1 Oa-d with respective ones of segments 1 Oa-d being available as redundant memory cells, for example, for respective portions of primary memory modules 1304-1307 which have failed. The number of memory cells assigned to each segment 13 1 Oa-d in redundant memory module 13 0 1, may be a fixed number, or may be flexibly allocatable to accommodate different numbers of failed memory circuits in respective primary memory modules 1304-1307.

Memory Redundangy Device FIG. 14 illustrates another aspect of the present invention which provides an implementation of row and column redundancy for a memory structure such as memory structure in FIG. 1, or memory structure 3 00 in FIG. 3. This aspect of the present invention can be implemented by employing fuses that are programmable, for example, during production.

Examples of such uses include metal fuses that are blown electrically, or by a focused laser; or a double-gated device, which can be permanently programmed. Although the technique can be applied to provide row redundancy, or column redundancy, or both, the present discussion will describe column redundancy in which both inputs and outputs may need the advantages of redundancy.

FIG. 14 shows an embodiment of this aspect of the invention herein having four pairs of columns 1402a-d with one redundant pair 1404. It is desirable to implement this aspect of the present invention as pairs of lines because a significant number of RAM failures occur in pairs, whether column or row. Nevertheless, this aspect of the present invention also contemplates single line redundancy. In general, the number of ftises in fuse box 1403 used to provide I redundancy can be logarithmically related to the number line pairs, e.g. , column pairs: 1092 (number of column pairs), where the number of column pairs includes the redundant pairs as well. Because fuses tend to be large, their number should be minimized, thus the logarithmic relation is advantageous. Fuse outputs 1405 are fed into decoder circuits 1406a-d, e.g., one fuse output per column pair. A fuse output creates what is referred to herein as a "shift pointer". The shift pointer indicates the shift signal in the column pair to be made redundant, and subsequent column pairs can then be inactivated. It is desirable that the signals 1405 from fuse box 1410 are decoded to generate shift signal 1412a-d at each column pair. When shift signal 1412a-d for a particular column pair 1402a-d location is selected, as decoded from fuse signals 1405, shift pointer 1412a-d is said to be pointing at this location. The shift signals for this column, and all subsequent columns to the right of the column of pair shift pointer also become inactive.

This aspect of the present invention can be illustrated additionally in FIG. 15A and FIG. 15B, by way of the aforementioned concept of "shift pointers." In FIG. 15A, three column pairs 1501, 1502, 1503, and one redundant column pair 1504 are shown. The shift procedure is conceptually indicated by way of "line diagrams". The top lines 1505-1508 of the line diagrams are representative of columns 1501-1504 within the memory core while bottom line pairs 1509 1511 are the data input/output pairs from the input/output buffers. When a shift signal, such as a signal 1405 in FIG. 14, for a particular column pair 1501-1503 is logical LOW, it is preferred that the data in 1509-1511 be connected to respective column 1501-1503 directly above it by multiplexers. FIG. 15B is illustrative of having a failed column state. When shift signal is logical HIGH, such as a signal 1405 in FIG. 14, a failed column is indicated, such as column 1552. Active columns 1550, 1551 remain unfaulted, and continue to receive their data via 1/0 lines 1554, 1555. However, because column 1552 has failed, data from 1/0 buffer 1556 can be multiplexed to the redundant column pair 1553. Diagrammatically, it appears that data in are shifted left while data out from the memory core columns are shifted right. By adjusting the location of the shift pointer, which generally is determined by the state of the fuses, the unused redundant column pair can be shifted to coincide with a nonfunctional column, e.g., column 1552, thereby repairing the column fault and boosting the fully fimctional memory yield.

Selector for Redundant Memory Circuit FIG. 16 illustrates yet another aspect of the present invention, in which selector 1600 is adapted to provi, de a form of redundancy. Selector 1600 can include a primary decoder circuit 1605, which may be a global word line decoder, which is coupled with a multiplexer 1610.

MUX 1610 can be activated by a redundancy circuit 1620, which may be a fuse system, programable memory, or other circuit capable of providing an activation signal 1630 to selector 1600 via MUX 16 10. Selector 1600 is suitable for implementing module- level redundancy, such as that described relative to module 1200 in FIG. 12, which may be row redundancy or column redundancy for a given implementation. In the ordinary course of operation, input word line I signal 1650 is decoded in decoder circuit 1605 and, in the absence of a fault on local word line 1670, the word line signal is passed to first local line 1680. In the event a fault is detected, MUX 1610, selects second local line 1660, which is preferred to be a redundant word line.

Fast Decoder with Row Redund nc FIG. 17 illustrates a preferred embodiment of selector 1600 in FIG. 16, in the form of decoder 1700 with row redundancy as realized in a hierarchical memory environment. Decoder 1700 may be particularly suitable for implementing module-level redundancy, such as that described relative to module 1200 in FIG. 12. Global decoder 1700, can operate similarly to the manner of asynchronously-resettable decoder 800 of FIG. 8. In general, decoder 1700 can be coupled with a first, designated memory row, and a second, alternative memory row. Although the second row may be a physical row ad acent the first memory row, and another of the originally designated rows of the memory module, the second row also may be a redundant row which is implemented in the module. Although row decoder 1700 decodes the first memory row under normal operations, it also is disposed to select and decode the second memory row in responsive to an alternative-row-select signal. Where the second row is a redundant row, it may be more suitable to deem the selection signal to be a "redundant-row- select" signal. The aforementioned row select signals are illustrated as inputs 1701 and 1702.

Thus, when input 1701 or 1702 is activated, decoder 1700 transfers the local word line signal, usually output on WL 1706, to be output on xL - Next 1705, which is coupled with an adjacent word line. In general, when a word line decoder, positioned at a particular location in a memory module, receives a shift signal, the remaining decoders subsequent to that decoder also shift, so that the last decoder in the sequence shifts its respective WL data to a redundant word line. Using a two-dimensional conceptual model where a redundant row is at the bottom of a model, this process may be described as having a fault at a particular position effect a downward shift of all local word lines at and below the position of the fault. Those local word lines above the position of the fault can remain unchanged.

Hybrid Single Port and Dual Port (R/W) Functionali Hierarchical memory module implementations realize significant time savings due in part to localized functionality. Signal propagation times at the local module tier tend to be substantially less than the typical access time of a larger memory structure, even those employing existing paged, banked, and segmented memory array, and register file schemes. Indeed, both read and write operations performed at the ftindamental module tier can occur within a fraction ofthe overall memory structure access time. Furthermore, because bitline sensing, in accordance with the present invention, is power-conservative, and does not result in a substantial decay of precharge voltages, the bitline voltage levels after an operation tend to be marginally reduced.

As a result, in certain preferred embodiments of the present invention, it is possible to perform I two operations back-to-back without an intervening pre-charge cycle, and to do so within a single access cycle of the overall memory structure. Therefore, although a memory device may be designed as to be single-port device, a preferred memory module embodiment functions similarly to a two-port memory device, which can afford such an embodiment a considerable advantage over prior art memory structures of comparable overall memory size.

FIG. 18 illustrates one particular embodiment of this aspect of the present invention, in memory structure 1800, where both local bitline sensing and local word line decoding are used, as described above. Memory structure 1800 includes memory module 1805 which is coupled with local word line decoder 1815 and local bit sense amplifier 1820. Within memory module 1805 are a predefined number of memory cells, for example, memory cell 1825, which is coupled with local word line decoder 1815 via local word line 1810, and local bit sense amplifier 1820 via local bitlines 1830. With typical single-port functionality, local bitlines 1830 are precharged prior to both READ and WRITE operations. During a typical READ operation, predecoder 183 5 activates the appropriate global word line decoder 1840, which, in turn, activates local word line decoder 1815. Once local word line decoder 1815 determines that associated memory cell 1825 is to be evaluated, it opens memory cell 1825 for evaluation, and activates local bit sense amplifier 1820. At the end of the local sensing period, local bit sense amplifier 1820 outputs the sensed data value onto global bitlines 1845. After global sense amplifier 1850 senses the data value, the data is output to the 1/0 buffer 1855. If a WRITE operation is to follow the READ operation, a typical single-port device would perform another precharge operation before the WRITE operation can commence.

In this particular embodiment of dual-port functionality, the predecoding step of a subsequent WRITE operation can commence essentially immediately after local bitline sense amplifier 1820 completes the evaluation of memory cell 1825, that is, at the inception of sensing cycle for global sense amplifier 1850, and prior to the data being available to 1/0 buffer 1855.

Thus, during the period encompassing the operation of global sense amplifier 1850 and 1/0 buffer 1855, and while the READ operation is still in progress, predecoder 1835 can receive and decode the address signals for a subsequent WRITE operation, and activate global word line decoder 1840 accordingly. In turn, global word line decoder 1840 activates local word line 1815 in anticipation of the impending WRITE operation. As soon as the datum is read out of 1/0 buffer 1855, the new datum associated with the WRITE cycle can be admitted to 1/0 buffer 1855 and immediately written to, for example, memory cell 1825, without a prior precharge cycle. In order to provide the memory addresses for these READ and WRITE operations in a manner consistent with this embodiment of the invention, it is preferred that the clocking cycle of predecoder 18 10 be faster than the access cycle of the overall memory structure 1800. For example, it may be desirable to adapt the predecoding clock cycle to be about twice, or perhaps greater than twice, the nominal access cycle for structure 1800. In this manner, a PRECHARGE- READ-WRITE operation can be performed upon the same memory cell within the same memory module in less I than one access cycle, thereby obtaining dual-port functionality from a single port device. It also is contemplated that the aforementioned embodiment can be adapted to realize three or more operations within a single access cycle, as permitted by the unused time during an access cycle.

Fortuitously, the enhanced functionality described above is particularly suited to large memory structures with comparatively small constituent modules, where the disparity between global and local access times is more pronounced. Moreover, in environments where delays due to signal propagation across interconnections, and to signal propagation delays through co embedded logic components may result in sufficient idle time for a memory structure, this enhanced functionality may advantageously make use of otherwise "wasted" time.

FIG. 19 illustrates high precision delay measurement (HPDM) circuit 1900, according to one aspect of the present invention, which can provide timing measurements of less than that of a single gate delay, relative to the underlying technology. These measurements can be, for example, of signal delays and periods, pulse widths, clock skews, etc. HPDM circuit 1900 also can provide pulse, trigger, and timing signals to other circuits, including sense amplifiers, word line decoders, clock devices, synchronizers, state machines, and the like. Indeed, HPDM circuit 1900 is a measurement circuit of widespread applicability. For example, HPDM circuit 1900 can be implemented within a high-performance microprocessor, where accurate measurement of internal time intervals, perhaps on the order of a few picoseconds, can be very difficult using devices external to the microprocessor. BPDM circuit 1900 can be used to precisely measure skew between and among signals, and thus also can be used to introduce or eliminate measured skew intervals. HDPM circuit 1900 also can be employed to characterize the signals ofindividual components, which may be unmatched, or poorly-matched components, as well as to bring such components into substantial synchrony. Furthermore, HPDM circuit 1900 can advantageously be used in register files, transceivers, adaptive circuits, and a myriad of other applications in which precise interval measurement is desirable in itself, and in the context of adapting the behavior of components, circuits, and systems, responsive to those measured intervals.

Advantageously, HPDM circuit 1900 can be devised to be responsive to operating voltage, design and process variations, design rule scaling, etc., relative to the underlying technology, including, without limitation, bipolar, nMOS, CMOS, BiCMOS, and GaAs technologies. Thus, an HPDM circuit 1900 designed to accurately measure intervals relevant to 1.8 micron technology will scales in operation to accurately measure intervals relevant to 0.18 micron technology. Although HPDM circuit 1900 can be adapted to measure fixed time intervals, and thus remain independent of process variations, design rule scaling, etc., it is preferred that HPDM circuit 1900 be allowed to respond to the technology and design rules at hand. In general, the core of an effective HPDM circuit capable of measuring intervals on the order of picoseconds, can require only a few scores of transistors which occupy a minimal footprint. This is in stark contrast to its counterpart in the human-scale domain, i.e., a an expensive, high-precision handheld, or bench side, electronic test device.

I One feature of HPDM circuit 1900 is modified ring oscillator 1905. As is well-known in the art of ring oscillators, the oscillation period, To, of a ring oscillator having N stages is approximately equal to 2NTD, where TD is the large-signal delay of the gate/inverter of each stage.

The predetermined oscillation period, To, can be chosen by selecting the number of gates to be employed in the ring oscillator. In general, TD is a function of the rise and fall times associated with a gate which, in turn, are related to the underlying parameters including, for example, gate transistor geometries and fabrication process. These parameters are manipulable such that TD can be tuned to deliver a predetermined gate delay time. In a preferred embodiment of the present invention in the context of a specific embodiment of a hierarchical memory structure, it is desirable that the parameters be related to a CMOS device implementation using 0. 18 micron (gm) design rules. However, a skilled artisan would realize that HPDM circuit 1900 is not limited thereto, and can be employed in other technologies, including, without limitation, bipolar, nMOS, CMOS, BiCMOS, GaAs, and SiGe technologies, regardless of design rule, and irrespective of whether implemented on Si substrate, SOI and its variants, etc. Although exemplary HPDM circuit 1900 employs seven (7) stage ring oscillator 1905, a greater or lesser number of stages may be used, depending upon the desired oscillation frequency.

In this example, ring oscillator 1905 includes NAND gate 1910, the output of which being designated as the first stage output 1920; and six inverter gates, 1911- 1916, whose outputs 192 1 - 1926 are respectively designated as the second through seventh stage outputs.

In addition to ring oscillator 1905, HPDM circuit 1900 can include memory elements 1930-1937, each of which being coupled with a preselected oscillator stage. The selection and arrangement of memory elements 1930-1937, make it possible to measure a minimum time quantum, TL, which is accurate to about one-half of a gate delay, that is, TL = Td2. The maximum length of time, T ,, that can usefully be measured by HPDM circuit 1900 is determinable by selecting one or more memory devices, or counters, to keep track of the number of oscillation cycles completed since the activation of oscillator 1905, for example, by ENABLE signal 1940.

Where the selected counter is a single 3 -bit device, for example, up to eight (8) complete cycles through oscillator 1905 can be detected, with each cycle being completed in To time. Therefore, using the single three-bit counter as an example, T. = 8 To. The remaining memory elements 1932-1937 can be used to indicate the point during a particular oscillator cycle at which ENABLE signal 1940 was deactivated, as determined by examining the respective states of given memory elements 1932-1937 after deactivation of oscillator 1905.

In HPDM circuit 1900, it is preferred that a k-bit positive edge- triggered counter (PET) 1930, and a k-bit negative edge-triggered counter (NET) 193 1, be coupled with first stage output 1920. Further, it is preferred that a dual edge-triggered counter (DET) 1932-1937 be coupled with respective outputs 1921-1925 of Oscillator 1905. In a particular embodiment of the invention, PET 1930 and NET 1931 are each selected to be three-bit counters (i.e., k = 3), and each of DET 1932-1937 are selected to be one-bit counters (latches). An advantage of using dual I edge detection in counters 1932-1937 is that the edge of a particular oscillation signal propagating through ring oscillator 1905 can be registered at all stages, and the location of the oscillation signal at a specific time can be determined therefrom. Because a propagating oscillation signal alternates polarity during sequentially subsequent passages through ring oscillator 1905, it is preferred to employ both NET circuit 1930 and PET 1931, and that the negative edge of a particular oscillation signal be sensed as the completion of the first looping event, or cycle, through ring oscillator 1905.

The operation of HPDM circuit 1900 can be summarized as follows: with Enablel, signal 1904 asserted HIGH, ring oscillator 1905 is in the STATIC mode, so that setting ResetL signal 1906 to LOW resets counters 1930-1937. By setting StartH signal 1907 to HIGH, sets RS flip flop 1908 which, in turn, sets ring oscillator 1905 to the ACTIVE mode by propagating an oscillation signal. Each edge of the oscillation signal can be traced by identifying the switching activity at each stage output 1920-1926. PET 193 0 and NET 193 1, which sense first stage output 1920 identify and count looping events. It is preferred that the maximum delay to be measured can be represented by the maximum count of PET 1930 and NET 193 1, so that the counters do not overflow. To stop the propagation of the oscillation signal through ring oscillator 1905, StopL signal 1909 is set LOW, RS Rip-flop 1908 is reset, and ring oscillator 1905 is returned to the STATIC mode of operation. Also, the data in counters 1930-1937 are isolated from output stages 1920-1926 by setting enL signal 1950 to LOW and enHsignal 1951 to HIGH. The digital data is then read out through ports lpos 1955, Ineg 1956, and del 1957. With knowledge of the average stage delay, the digital data then can be interpreted to provide an accurate measurement, in real time units, of the interval during which ring oscillator 1905 was in the ACTIVE mode of operation. HPDM circuit 1900 can be configured to provide, for example, a precise clock or triggering signal, such as TRIG signal 1945, after the passage of a predetermined quantum of time. Within the context of a memory system, such quantum of time can be, for example, the time necessary to sense the state of a memory cell, to keep active a wordline, etc. The average stage delay through stages 1910-1916 can be determined by operating ring oscillator 1905 for a predetermined averaging time by asserting StartH 1907 and StopL 1909 to HIGH, thereby incrementing counters 1930-1937. In a preferred embodiment of the present invention, the overflow of NET 1931 is tracked, with each overflow event being indicative of 2' looping events through ring oscillator 1905. It is preferred that this tracking be effected by a divider circuit, for example, DIVIDE-BY-64 circuit 1953. At the end of the predetermined averaging time, data from divider 1953 may be read out through port RO - div64 1954 as a waveform, and then analyzed to determine the average oscillator stage delay. However, a skilled artisan would realize that the central functionality of HPDM circuit 1900, i.e., to provide precise measurement of a predetermined time quantum, would remain unaltered if DIVIDE-BY-64 circuit 1953, or similar divider circuit, were not included therein.

HPDM circuit 1900 can be used for many timing applications whether or not in the I context of a memory structure, for example, to precisely shape pulsed waveforms and duty cycles; to skew, de-skew across one or more clocked circuits, or to measure the skew of such circuits; to provide high-precision test data; to indicate the beginning, end, or duration of a signal or event; and so forth. Furthermore, HPDM circuit 1900 can be applied to innumerable electronic devices other than memory structures, where precise timing measurement is desired.

Accurate self-timed circuits are important features of robust, low-power memories.

Replica bitline techniques have been described in the prior art to match the timing of control circuits and sense amplifiers to the memory cell characteristics, over wide variations in process, temperature, and operation voltage. One of the problems with some prior art schemes is that split dummy bitlines cluster word-lines together into groups, and thus only one word-line can be activated during a memory cycle. Before a subsequent activation of a word- line within the same group, the dummy bitlines must be precharged, creating an undesirable delay. The difflusion replica delay technique of the present invention substantially matches the capacitance of a dummy bitline by using a diffusion capacitor, preferably for each row. Some prior art techniques employed replica bit-columns which can add to undesirable operational delays. FIG. 20 illustrates the diffusion replica timing circuit 2000 which includes transistor 2005 and diffusion capacitance 2010. It is desirable that transistor 2005 be an NMOSFET transistor which, preferably, is substantially identical to an access transistor chain, if such is used in the memory cells of the memory structure (not shown). It also is desirable that the capacitance of diffusion capacitor 2010 is substantially matched to the capacitance of the associated bitline (not shown).

This capacitance can be a predetermined ratio of the total bitline capacitance, with the ratio of the diffusion capacitance to total bitline capacitance remaining substantially constant over process, temperature and voltage variations. The total bitline capacitance can include both the bitline metal and diffusion capacitances. In this fashion, all rows in a memory device which use timing circuit 2000 can be independently accessible with substantially fully-operation self-timing, even when another row in the same memory module has been activated, and is not yet precharged. Thus, write-after-read operations may be multiplexed into a memory module without substantial access time or area penalties. Thus, it is desirable to employ diffusion replica delay circuit 2000 in a memory structure such as memory structure 1800, described in FIG. 18.

Diffusion replica delay circuit 2000 can be used to determine the decay time of a bitline before a sense amplifier is activated, halting the decay on the bitline. In this manner, bitline decay voltage can be limited to a relatively small magnitude, thus saving power and decreasing memory access time. Furthermore, timing circuit 2000 can be used to accurately generate many timing signals in a memory structure such as structure 1800 in FIG. 18, including, without limitation, precharge, write, and shut-off timing signals.

FIG. 21 illustrates an embodiment of the diffusion replica delay circuit 2000 in FIG. 20.

Word-line activation of a memory cell frequency is pulsed to limit the voltage swing on the high capacitance bitlines, in order to minimize power consumption, particularly in wide word length I memory structures. In order to accurately control the magnitude of a bitline voltage swing, dummy bitlines can be used. It is desirable that these dummy bitlines have a capacitance which is a predefined fraction of the actual bitline capacitance. In such a device, the capacitance ratio between dummy bitlines and real bitlines can affect the voltage swing on the real bitlines. In prior art devices using dummy bitlines, a global dummy bitline for a memory block having a global reset loop has been utilized. Such prior art schemes using global resetting tends to deliver pulse widths of a duration substantially equivalent to the delay of global word-line drivers. Such an extend pulse width allows for a bitline voltage swing which can be in excess of what actually is required to activate a sense amplifier. This is undesirable in fast memory structures, because the additional, and unnecessary, voltage swing translates into a slower structure with greater power requirements. In one aspect of the present invention, dummy bitlines are preferably partitioned such that the local bitlines generally exhibit a small capacitance and a short discharge time. Word-line pulse signals of very short duration (e.g., 500 ps or less) are desirable in order to limit the bitline voltage swing. It also may be desirable to provide local reset of split dummy bitlines to provide very short word-line pulses. Replica word-line 2110 can be used to minimize the delay between activation of memory cell 2120 and related sense amplifier 2130. Such local signaling is preferred over global signal distribution on relatively long, highly capacitive word lines. Word-line 2140 activates dummy cell 2150 along with associated memory cell 2120, which is to be accessed. Dummy cell 2150 can be part of dummy column 2160 which may be split into small groups (for example, eight or sixteen groups). The size of each split dummy group can be changed to adjust the voltage swing on the bitline. When a dummy bitline is completely discharged, reset signal 2170 can be locally generated which pulls word-line 2140 substantially to ground.

FIG. 22A illustrates controlled voltage swing data bus circuit (CVS) 2200 which can be useful in realizing lower power, high speed, and dense interconnection buses. CVS 2200 can reduce bus power consumption by imposing a limited, controlled voltage swing on bus 2215.

In an essential configuration, CVS 2000 can include inverter 2205, pMOS pass transistor T2 2210, and one nMOS discharge transistor, such as transistor Tla 2205a. Both transistors Tla 2205 a, and T2 22 10 can be programmed to control the rate and extent of voltage swings on bus 2215 such that a first preselected bus operational characteristic is provided in response to input signal 2220a. Additional discharge transistors Tlb 2205b and TIc 2205c can be coupled with pass transistor T2 2210, and individually programmed to respectively provide a second preselected bus operational characteristic, as well as a third preselected bus operational characteristic, responsive to respective input signals 2220b, 2220c. The preselected bus operational characteristic can be for example, the rate of discharge of the bus voltage through the respective discharge transistor Tla 2205a, TIb 2205b, and TIc 2205c, such that bus 2215 is disposed to provide encoded signals, or multilevel logic, thereon. For example, as depicted in FIG. 22A, CVS 2200 can provide three distinct logic levels. Additional discharge transistors, I programmed to provide yet additional logic levels also may be used. Thus, it is possible for bus 2215 to replace two or more lines. Concurrently with effecting a reduction in power consumption, the limited bus voltage swing advantageously tends to increase the speed of the bus.

FIG. 22B illustrates a bidirectional data bus transfer circuit (DBDT) 2250 which employs cross-linked inverters I1 2260 and 12 2270 to couple BUS 1 2252 with BUS 2254. It is desirable to incorporate a clocked charge/discharge circuit with DBDT 2250. Coupled with inverterI1 2260 is clocked charge transistor MPC1 2266 and clocked discharge transistor MNCI 2268. Similarly, inverter 12 2270 is coupled with clocked charge transistor MPC2 2276 and clocked discharge transistor MNC2 2278. Transistors MPC 12266, MNC 12268, MPC2 2276, and MNC2 2278 are preferred to be driven by clock signal 2280.

Beginning with clock signal 2280 going LOW, charge transistors MPC 12266 and MPC2 2276 turn ON, allowing BUS I input node 2256 and BUS 2 input node 2258 to be precharged to HIGH. Additionally, discharge transistors MNC 12268 and MNC2 2278 are turned OFF, so that no substantial discharge occurs. By taking input nodes 2256, 2258 to HIGH, respective signals propagate through, and are inverted by inverters 112260 and 12 2270 providing a LOW signal to BUS I pass transistor MP 12 2262 and BUS 2 pass MP22 2272, respectively, allowing the signal on BUS 12252 to be admitted to input node 2256, and then to pass through to BUS2 input node 2258 to BUS 2 2254, and vice versa. When clock signal 2280 rises to HIGH, both charge transistors MPC 12266 and MPC2 2276 turn OFF, and discharge transistors NINC 12268 and MNC2 2278 turn ON, latching the data onto BUS 12252 and BUS 2 2254. Upon the next LOW phase of clock signal 2280, a changed signal value on either BUS 12252 or BUS 2 2254 will propagate between the buses.

Many alterations and modifications may be made by those having ordinary skill in the art without departing from the scope of the invention. Therefore, it must be understood that the illustrated embodiments have been set forth only for the purposes of example, and that it should not be taken as limiting the invention as defined by the following claims. The following claims are, therefore, to be read to include not only the combination of elements which are literally set forth but all equivalent elements for performing substantially the same function in substantially the same way to obtain substantially the same result. The claims are thus to be understood to include what is specifically illustrated and described above, what is conceptually equivalent, and also what incorporates the essential idea of the invention.

## Claims

1. A memory module (605) comprising:
a. a memory cell (610) having a memory state;
b. a local sense amplifier (608a,b) coupled with the memory cell (610), the local sense amplifier (608a,b) sensing the memory state and producing a local memory state signal representative thereof,
c. a global sense amplifier (640) coupled with the local sense amplifier (608a,b), the global sense amplifier (640) sensing the local memory state signal and producing a global memory state signal representative thereof;
d. a local wordline decoder (615a-c) coupled with the memory cell (610), the local wordline decoder (615a-c) generating a local memory cell selection signal in response to a local decoder selection signal;
e. a global wordline decoder (620) coupled with the local wordline decoder (615a-c), the global wordline decoder (620) producing the local decoder selection signal responsive to a global selection signal, at least two of the local memory state signal, global memory state signal, local decoder selection signal and global selection signal comprising a limited swing voltage signal; and
f. a diffusion replica delay circuit (2000) constraining the limited swing voltage signal; wherein the diffusion replica delay circuit (2000) is configured to use dummy bitlines having a capacitance which is a predefined fraction of an actual bitline capacitance to accurately control a magnitude of a bitline voltage swing.

2. The memory module (605) of Claim 1, wherein the diffusion replica delay circuit (2000) comprises dummy cells operably coupled with the local wordline decoder and the local sense amplifier, wherein the dummy cells comprise the dummy bit lines.

3. The memory module (605) of Claim 1, further comprising a plurality of memory cells (610) coupled with the local sense amplifier (608a,b).

4. The memory module (605) of claim 3, further comprising
a plurality of local sense amplifiers (608a,b) wherein the global sense amplifier (640) is coupled with the plurality of local sense amplifiers (608a,b), a selected one of the plurality of local sense amplifiers (608a,b) sensing the memory state and producing a local memory state signal representative thereof, the global sense amplifier (640) sensing the local memory state signal and producing a global memory state signal representative thereof, and wherein the plurality of memory cells (610) coupled with the global sense amplifier (640) is disposed as a memory column.

5. The memory module (605) of Claim 3, wherein the plurality of memory cells (610) comprises a memory cell subcolumn, and the local sense amplifier (608a,b) is coupled with a single memory cell subcolumn.

6. The memory module (605) of Claim 3, wherein the plurality of memory cells (610) is partitioned to form a plurality of memory cell subcolumns each having a respective plurality of memory cells (610), and the local sense amplifier (608a,b) is coupled with the plurality of memory cell subcolumns.

7. The memory module (605) of Claim 4, further comprising a plurality of global sense amplifiers, selected ones of the plurality of global sense amplifiers having a respective plurality of local sense amplifiers (608a,b) coupled therewith, and selected ones of the plurality of local sense amplifiers (608a,b) being coupled with a respective plurality of memory cells (610), selected others of the plurality of global sense amplifiers being coupled with the selected ones such that the selected ones of the plurality of global sense amplifiers are local sense amplifiers relative to the selected others of the plurality of global sense amplifiers, each local sense amplifier (608a,b) producing a respective local memory state signal to which a corresponding global sense amplifier is responsive.

8. The memory module (605) of claim 1, wherein at least three of the local memory state signal, global memory state signal, local decoder selection signal and global selection signal comprise a limited swing voltage signal.

9. The memory module (605) of claim 1, wherein each of the local memory state signal, global memory state signal, local decoder selection signal and global selection signal comprises a limited swing voltage signal.

10. The memory module (605) of Claim 8, wherein the global sense amplifier (640) produces a limited swing voltage signal representative of the memory state.

## Patentansprüche

1. Speichermodul (605) mit:
a. einer Speicherzelle (610), die einen Speicherzustand aufweist;
b. einem lokalen Leseverstärker (608a,b), der mit der Speicherzelle (610) gekoppelt ist, wobei der lokale Leseverstärker (608a,b) den Speicherzustand liest und ein lokales Speicherzustandssignal erzeugt, das repräsentativ dafür ist,
c. einem globalen Leseverstärker (640), der mit dem lokalen Leseverstärker (608a,b) gekoppelt ist, wobei der globale Leseverstärker (640) das lokale Speicherzustandssignal liest und ein globales Speicherzustandssignal erzeugt, das repräsentativ dafür ist,
d. einem lokalen Wortleitungsdecoder (615a-c), der mit der Speicherzelle (610) gekoppelt ist, wobei der lokale Wortleitungsdecoder (615a-c) ein lokales Speicherzellen-Selektionssignal im Ansprechen auf ein lokales Decoder-Selektionssignal erzeugt;
e. einem globalen Wortleitungsdecoder (620), der mit dem lokalen Wortleitungsdecoder (615a-c) gekoppelt ist, wobei der globale Wortleitungsdecoder (620) das lokale Decoder-Selektionssignal im Ansprechen auf ein globales Selektionssignal erzeugt, wobei wenigstens zwei von dem lokalen Speicherzustandssignal, dem globalen Speicherzustandssignal, dem lokalen Decoder-Selektionssignal und dem globalen Selektionssignal ein Signal mit begrenzter Spannungsschwankung aufweisen; und
f. einer Diffusionsreplikations-Verzögerungsschaltung (2000), die das Signal mit begrenzter Spannungsschwankung einschränkt; wobei die Diffusionsreplikations-Verzögerungsschaltung (2000) so konfiguriert ist, dass sie Dummy-Bitleitungen benutzt, die eine Kapazität aufweisen, die ein vordefinierter Bruchteil einer tatsächlichen Bitleitungskapazität ist, um eine Größe einer Bitleitungs-Spannungsschwankung genau zu steuern.

2. Speichermodul (605) nach Anspruch 1, wobei die Diffusionsreplikations-Verzögerungsschaltung (2000) Dummy-Zellen aufweist, die betriebsfähig mit dem lokalen Wortleitungsdecoder und dem lokalen Leseverstärker gekoppelt sind, wobei die Dummy-Zellen die Dummy-Bitleitungen aufweisen.

3. Speichermodul (605) nach Anspruch 1, das des Weiteren eine Vielzahl von Speicherzellen (610) aufweist, die mit dem lokalen Leseverstärker (608a,b) gekoppelt ist.

4. Speichermodul (605) nach Anspruch 3, des Weiteren mit:
einer Vielzahl von lokalen Leseverstärkern (608a,b), wobei der globale Leseverstärker (640) mit der Vielzahl von lokalen Leseverstärkern (608a,b) gekoppelt ist, ein ausgewählter lokaler Leseverstärker von der Vielzahl von lokalen Leseverstärkern (608a,b) den Speicherzustand liest und ein lokales Speicherzustandssignal erzeugt, das repräsentativ dafür ist, der globale Leseverstärker (640) das lokale Speicherzustandssignal liest und ein globales Speicherzustandssignal erzeugt, das repräsentativ dafür ist, und wobei die Vielzahl von Speicherzellen (610), die mit dem globalen Leseverstärker (640) gekoppelt ist, als eine Speicherspalte angeordnet ist.

5. Speichermodul (605) nach Anspruch 3, wobei die Vielzahl von Speicherzellen (610) eine Speicherzellen-Unterspalte aufweist und der lokale Leseverstärker (608a,b) mit einer einzelnen Speicherzellen-Unterspalte gekoppelt ist.

6. Speichermodul (605) nach Anspruch 3, wobei die Vielzahl von Speicherzellen (610) partitioniert ist, um eine Vielzahl von Speicherzellen-Unterspalten zu bilden, von denen jede eine jeweilige Vielzahl von Speicherzellen (610) aufweist, und der lokale Leseverstärker (608a,b) mit der Vielzahl von Speicherzellen-Unterspalten gekoppelt ist.

7. Speichermodul (605) nach Anspruch 4, des Weiteren mit einer Vielzahl von globalen Leseverstärkern, wobei mit ausgewählten einen von der Vielzahl von globalen Leseverstärkern eine jeweilige Vielzahl von lokalen Leseverstärkern (608a,b) gekoppelt ist, und ausgewählte lokale Leseverstärker von der Vielzahl von lokalen Leseverstärkern (608a,b) mit einer jeweiligen Vielzahl von Speicherzellen (610) gekoppelt sind, ausgewählte andere von der Vielzahl von globalen Leseverstärkern mit den ausgewählten einen derart gekoppelt sind, dass die ausgewählten einen von der Vielzahl von globalen Leseverstärkern lokale Leseverstärker relativ zu den ausgewählten anderen von der Vielzahl von globalen Leseverstärkern sind, wobei jeder lokale Leseverstärker (608a,b) ein jeweiliges lokales Speicherzustandssignal erzeugt, auf das ein entsprechender globaler Leseverstärker anspricht.

8. Speichermodul (605) nach Anspruch 1, wobei wenigstens drei von dem lokalen Speicherzustandssignal, dem globalen Speicherzustandssignal, dem lokalen Decoder-Selektionssignal und dem globalen Selektionssignal ein Signal mit begrenzter Spannungsschwankung aufweisen.

9. Speichermodul (605) nach Anspruch 1, wobei jedes von dem lokalen Speicherzustandssignal, dem globalen Speicherzustandssignal, dem lokalen Decoder-Selektionssignal und dem globalen Selektionssignal ein Signal mit begrenzter Spannungsschwankung aufweist.

10. Speichermodul (605) nach Anspruch 8, wobei der globale Leseverstärker (640) ein Signal mit begrenzter Spannungsschwankung erzeugt, das repräsentativ für den Spannungszustand ist.

## Revendications

1. Module de mémoire (605) comprenant :
a. une cellule de mémoire (610) ayant un état de mémoire ;
b. un amplificateur local de détection (608a,b) couplé avec la cellule de mémoire (610), l'amplificateur local de détection (608a,b) détectant l'état de mémoire et produisant un signal local d'état de mémoire représentatif de celui-ci ;
c. un amplificateur global de détection (640) couplé avec l'amplificateur local de détection (608a,b), l'amplificateur global de détection (640) détectant le signal local d'état de mémoire et produisant un signal global d'état de mémoire représentatif de celui-ci ;
d. un décodeur local de canal mot (615a-c) couplé avec la cellule de mémoire (610), le décodeur local de canal mot (615a-c) générant un signal local de sélection de cellule de mémoire en réponse à un signal local de sélection de décodeur ;
e. un décodeur global de canal mot (620) couplé avec le décodeur local de canal mot (615a-c), le décodeur global de canal mot (620) produisant le signal local de sélection de décodeur en réponse à un signal global de sélection, au moins deux du signal local d'état de mémoire, du signal global d'état de mémoire, du signal local de sélection de décodeur et du signal global de sélection comprenant un signal de tension à excursion limitée ; et
f. un circuit de retard de réplication de diffusion (2000) contraignant le signal de tension à excursion limitée ; dans lequel le circuit de retard de réplication de diffusion (2000) est configuré pour utiliser des canaux bit factices ayant une capacitance qui est une fraction prédéfinie d'une capacitance réelle de canal bit pour contrôler précisément une grandeur d'une excursion de tension de canal bit.

2. Module de mémoire (605) selon la revendication 1, dans lequel le circuit de retard de réplication de diffusion (2000) comprend des cellules factices opérationnellement couplées avec le décodeur local de canal mot et l'amplificateur local de détection, dans lequel les cellules factices comprennent les canaux bit factices.

3. Module de mémoire (605) selon la revendication 1, comprenant en outre une pluralité de cellules de mémoire (610) couplée avec l'amplificateur local de détection (608a,b).

4. Module de mémoire (605) selon la revendication 3, comprenant en outre
une pluralité d'amplificateurs locaux de détection (608a,b) dans lequel l'amplificateur global de détection (640) est couplé avec la pluralité d'amplificateurs locaux de détection (608a,b), un sélectionné parmi la pluralité d'amplificateurs locaux de détection (608a,b) détectant l'état de mémoire et produisant un signal local d'état de mémoire représentatif de celui-ci, l'amplificateur global de détection (640) détectant le signal local d'état de mémoire et produisant un signal global d'état de mémoire représentatif de celui-ci, et dans lequel la pluralité de cellules de mémoire (610) couplée avec l'amplificateur global de détection (640) est disposée comme une colonne de mémoire.

5. Module de mémoire (605) selon la revendication 3, dans lequel la pluralité de cellules de mémoire (610) comprend une sous-colonne de cellules de mémoire, et l'amplificateur local de détection (608a,b) est couplé avec une sous-colonne unique de cellules de mémoire.

6. Module de mémoire (605) selon la revendication 3, dans lequel la pluralité de cellules de mémoire (610) est partitionnée pour former une pluralité de sous-colonnes de cellules de mémoire ayant chacune une pluralité de cellules de mémoire (610) respective, et l'amplificateur local de détection (608a,b) est couplé avec la pluralité de sous-colonnes de cellules de mémoire.

7. Module de mémoire (605) selon la revendication 4, comprenant en outre une pluralité d'amplificateurs globaux de détection, certains sélectionnés parmi la pluralité d'amplificateurs globaux de détection ayant une pluralité respective d'amplificateurs locaux de détection (608a,b) couplée avec ceux-ci, et certains sélectionnés parmi la pluralité respective d'amplificateurs locaux de détection (608a,b) étant couplés avec une pluralité respective de cellules de mémoire (610), certains autres sélectionnés parmi la pluralité d'amplificateurs globaux de détection étant couplés avec ceux sélectionnés de telle sorte que ceux sélectionnés parmi la pluralité d'amplificateurs globaux de détection sont des amplificateurs locaux de détection par rapport aux autres sélectionnés parmi la pluralité d'amplificateurs globaux de détection, chaque amplificateur local de détection (608a,b) produisant un signal local d'état de mémoire respectif auquel un amplificateur global de détection correspondant réagit.

8. Module de mémoire (605) selon la revendication 1, dans lequel au moins trois parmi le signal local d'état de mémoire, le signal global d'état de mémoire, le signal local de sélection de décodeur et le signal global de sélection comprennent un signal de tension à excursion limitée.

9. Module de mémoire (605) selon la revendication 1, dans lequel chacun parmi le signal local d'état de mémoire, le signal global d'état de mémoire, le signal local de sélection de décodeur et le signal global de sélection comprend un signal de tension à excursion limitée.

10. Module de mémoire (605) selon la revendication 8, dans lequel l'amplificateur global de détection (640) produit un signal de tension à excursion limitée représentatif de l'état de mémoire.
